(19) Europäisches Patentamt
European Patent Office
Office européen des brevets

(11) EP 2 311 112 B1

(12) EUROPÄISCHE PATENTSCHRIFT

(45) Veröffentlichungstag und Bekanntmachung des Hinweises auf die Patenterteilung:
**14.03.2012 Patentblatt 2012/11**

(21) Anmeldenummer: **09777051.5**

(22) Anmeldetag: **08.07.2009**

(51) Int Cl.:
***H01L 51/00*** *(2006.01)*

(86) Internationale Anmeldenummer:
**PCT/EP2009/004955**

(87) Internationale Veröffentlichungsnummer:
**WO 2010/015307 (11.02.2010 Gazette 2010/06)**

(54) **ELEKTRONISCHE VORRICHTUNG ENTHALTEND METALLKOMPLEXE MIT ISONITRILLIGANDEN**

ELECTRONIC DEVICES COMPRISING METAL COMPLEXES HAVING ISONITRILE LIGANDS

DISPOSITIF ÉLECTRONIQUE CONTENANT DES COMPLEXES MÉTALLIQUES AVEC DES LIGANDS ISONITRILES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **04.08.2008 DE 102008036247**

(43) Veröffentlichungstag der Anmeldung:
**20.04.2011 Patentblatt 2011/16**

(73) Patentinhaber: **Merck Patent GmbH**
**64293 Darmstadt (DE)**

(72) Erfinder:
- **STOESSEL, Philipp**
  **60487 Frankfurt (DE)**
- **HEIL, Holger**
  **60389 Frankfurt (DE)**
- **JOOSTEN, Dominik**
  **60487 Frankfurt (DE)**
- **PFLUMM, Christof**
  **60316 Frankfurt (DE)**
- **GERHARD, Anja**
  **63329 Egelsbach (DE)**

(56) Entgegenhaltungen:
**WO-A-2005/086251 WO-A-2008/003464**

- **YOSHIHITO KUNUGI ET AL: "A Vapochromic LED" JOURNAL OF THE AMERICAN CHEMICAL SOCIETY, AMERICAN CHEMICAL SOCIETY, WASHINGTON, DC. US, Bd. 120, Nr. 3, 1. März 1998 (1998-03-01), Seiten 589-590, XP007909751 ISSN: 0002-7863 [gefunden am 1998-01-07]**
- **Y. YAMAMOTO, H. YAMAZAKI: "Studies on the Interaction of Isocyanides with Transition Metal Complexes. XXVII: Preparation of Zerovalent Isocyanide Complexes of Chromium, Molybdenum and Tungsten. The Crystal Structure of Hexakis(2,6-Xylyl Isocyanide) Molybdenum Containing Benzene as a Solvated Molecule" JOURNAL OF ORGANOMETALLIC CHEMISTRY, Bd. 282, 1985, Seiten 191-200, XP002545134 in der Anmeldung erwähnt**
- **DANIEL T PLUMMER ET AL: "Synthesis of chelating bidentate and tridentate cyano ligands and their complexes with Group VII metal carbonyls", INORGANIC CHEMISTRY, vol. 22, no. 24, 1 November 1983 (1983-11-01), pages 3492-3497, XP55002921, DOI: 10.1021/ic00166a003**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 311 112 B1

Printed by Jouve, 75001 PARIS (FR)

## Beschreibung

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. In den letzten Jahren werden als emittierende Materialien zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf. So sollten die physikalischen Eigenschaften von phosphoreszierenden OLEDs im Hinblick auf die Stabilität der Metallkomplexe, Effizienz, Betriebsspannung und Lebensdauer noch verbessert werden. Auch bei anderen in organischen Elektrolumineszenzvorrichtungen verwendeten Verbindungen, wie beispielsweise Matrixmaterialien und Ladungstransportmaterialien, sind noch weitere Verbesserungen wünschenswert.

Gemäß dem Stand der Technik werden in phosphoreszierenden OLEDs als Triplettemitter meist Iridiumkomplexe bzw. Platinkomplexe eingesetzt. Eine Verbesserung dieser OLEDs konnte dadurch erzielt werden, dass Metallkomplexe mit polypodalem Liganden bzw. Kryptate eingesetzt wurden, wodurch die Komplexe eine höhere thermische Stabilität aufweisen, was zu einer höheren Lebensdauer der OLEDs führt (WO 04/081017, WO 05/113563, WO 06/008069). Jedoch sind noch weitere Verbesserungen der Komplexe erforderlich, um insbesondere Verbesserungen in Bezug auf die Effizienz und die Lebensdauer von Elektrolumineszenzvorrichtungen, welche diese Komplexe enthalten, zu erzielen.

Auch die Verwendung von Wolframkomplexen in OLEDs wurde bereits in der Literatur beschrieben (JP 2006/303315). Es werden darin jedoch nur Wolframkomplexe mit Pyridinliganden, wie z. B. Bipyridin oder Terpyridin, und mit Phosphinliganden explizit offenbart.

Eine Eigenschaft von phosphoreszierenden Metallkomplexen, wie sie gemäß dem Stand der Technik eingesetzt werden, sind die im Vergleich zu fluoreszierenden Verbindungen sehr langen Lumineszenzlebensdauern. So liegen die Phosphoreszenzlebensdauern von Iridiumkomplexen bei Raumtemperatur üblicherweise in der Größenordnung von 0.5 bis 5 $\mu$s und von Platinkomplexen in der Größenordnung von 3 bis 30 $\mu$s. Insbesondere bei Passiv-Matrix-Ansteuerung von organischen Elektrolumineszenzvorrichtungen kann dies zu Problemen führen, da durch die dabei benötigten hohen Helligkeiten eine Sättigung des angeregten Zustands erzeugt wird, so dass bei hoher Helligkeit die Effizienz stark abfällt. In diesem Bereich sind somit weitere Verbesserungen erforderlich.

Aufgabe der vorliegenden Erfindung ist daher die Bereitstellung neuer elektronischer Vorrichtungen enthaltend Metallkomplexe als Emitter, welche rot, orange, gelb, grün oder blau phosphoreszieren und welche hier zu Verbesserungen führen.

Überraschend wurde gefunden, dass organische Elektrolumineszenzvorrichtungen enthaltend die näher beschriebenen Metallkomplexe, welche Isonitrilliganden enthalten, diese Aufgabe lösen und zu deutlichen Verbesserungen der organischen Elektrolumineszenzvorrichtung führen, insbesondere hinsichtlich der operativen Lebensdauer und der Effizienz bei hoher Helligkeit. Organische Elektrolumineszenzvorrichtungen, welche diese Komplexe enthalten, sind daher der Gegenstand der vorliegenden Erfindung.

Stand der Technik sind organische Elektrolumineszenzvorrichtungen, die tetrakoodinierte Metallkomplexe mit Isonitrilliganden enthalten (WO 08/003464). Aus dieser Offenbarung geht jedoch nicht hervor, dass diese Komplexe besonders gute Effizienz und kurze Lumineszenzlebensdauern zeigen. Insbesondere wird mit diesen tetrakoordinierten, planaren Komplexen ein völlig anderer Emissionsmechanismus beobachtet, bei dem die Übergänge, die zur Emission führen, auf Metall-Metall-Wechselwirkungen zwischen benachbarten Komplexen basieren. Daher sind hohe Konzentrationen des Metallkomplexes erforderlich, was insbesondere in Anbetracht der Seltenheit von Edelmetallen nicht wünschenswert ist.

Aus der WO 2005/086251 sind neutrale elektronenreiche Metallkomplexe als Dotand zur Dotierung eines organischen halbleitenden Matrixmaterials bekannt, insbesondere dinukleare Komplexe mit Metall-Metall-Bindung.

Die Synthese eines Wolfram-Hexaisonitrilkomplexes mit monodentaten Isonitrilliganden ist in Y. Yamamoto et al, J. Organomet. Chem., 1985, 282, 191-200; M. O. Albers et al., J. Chem. Edu., 1986, 63(5), 444-447; und N. J. Coville, **1982,** *65,* L7-L8 beschrieben. Anwendungen dieses Komplexes, insbesondere Anwendungen in elektronischen Vorrichtungen sind nicht offenbart.

Auch hexakoordinierte Metallkomplexe mit polydentaten Isonitrilliganden sind in der Literatur bekannt (z. B. F. E. Hahn et al., J. Organomet. Chem. 1994, 467, 103-111; F. E. Hahn et al., J. Organomet. Chem. 1991, 410, C9-C12; F. E. Hahn et al., Angew. Chem. 1992, 104, 1218-1221; F. E. Hahn et al., Angew. Chem. 1991, 103, 213-215). Mit diesen Komplexen wurden jedoch nur allgemeine strukturchemische Untersuchungen durchgeführt. Die Anwendung derartiger Komplexe in organischen Elektrolumineszenzvorrichtungen ist nicht offenbart.

Weiterhin sind Metallkomplexe mit tridentaten Cyanoliganden bekannt (D. T. Plummer et al., Inorganic Chemistry 1983, 22, 3492-3497). Die Anwendung derartiger Komplexe in organischen Elektrolumineszenzvorrichtungen ist nicht offenbart.

Gegenstand der Erfindung sind somit elektronische Vorrichtungen, enthaltend mindestens einen Metallkomplex gemäß Formel (1),

$$(L)_y M \left[ C{\equiv}N{-}R \right]_x$$

**Formel (1)**

wobei für die verwendeten Symbole und Indizes gilt:

M ist ein penta- oder hexakoordiniertes Übergangsmetall;

L ist bei jedem Auftreten gleich oder verschieden ein mono-, bi- oder tridentater Ligand, der an das Metall M bindet und der durch einen oder mehrere Reste $R^1$ substituiert sein kann; dabei kann der Ligand L auch an den Rest R der Isonitrilgruppe gebunden sein;

R ist bei jedem Auftreten gleich oder verschieden ein organischer Substituent mit 1 bis 60 C-Atomen, der durch einen oder mehrere Substituenten $R^1$ substituiert sein kann; dabei können mehrere Reste R auch miteinander verknüpft sein und dadurch einen mehrzähnigen Liganden bilden; außerdem kann der Rest R auch mit dem Liganden L verknüpft sein;

$R^1$ ist bei jedem Auftreten gleich oder verschieden H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere bevorzugt nicht benachbarte $CH_2$-Gruppen durch $R^2C=CR^2$, C=C, $Si(R^2)_2$ $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination dieser Systeme; dabei können zwei oder mehrere Substituenten $R^1$ auch miteinander ein mono- oder polycyclisches aliphatisches, aromatisches und/oder benzoannelliertes Ringsystem bilden;

$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch D oder F ersetzt sein können; dabei können zwei oder mehrere Substituenten $R^2$ auch miteinander ein mono- oder polycyclisches, aliphatisches oder aromatisches Ringsystem bilden;

x ist 3, 4, 5 oder 6;

y ist 0, 1, 2 oder 3 mit der Maßgabe, dass eine Koordinationszahl am Metall von 5 oder 6 erreicht wird.

Die Indizes x und y werden so gewählt, dass die Koordinationszahl am Metall M insgesamt, je nach Metall, 5 oder 6 beträgt. Es ist generell bekannt, dass Metallkoordinationsverbindungen abhängig vom gewählten Metallatom und von der Oxidationsstufe des Metallsatoms unterschiedliche Koordinationszahlen aufweisen, also eine unterschiedliche Anzahl von Liganden binden. Da die bevorzugten Koordinationszahlen von Metallen bzw. Metallionen in verschiedenen Oxidationsstufen zum allgemeinen Fachwissen des Fachmanns auf dem Gebiet der metallorganischen Chemie bzw. der Koordinationschemie gehören, ist es für den Fachmann ein Leichtes, je nach Metall und dessen Oxidationsstufe und je nach genauer Struktur des Liganden L eine geeignete Anzahl Liganden zu verwenden und somit die Indizes x und y geeignet zu wählen.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen.

Die Liganden vom Typ C≡N-R sind Isonitrile (= Isocyanide), welche über ein Kohlenstoffatom an das Metall koordinieren. Dabei ist der Ligand entweder monodentat, wenn R eine monovalente Gruppe darstellt, oder er ist bidentat, wenn R eine bivalente Gruppe darstellt, die entweder zwei Isonitrilgruppen oder eine Isonitrilgruppe und den Liganden L miteinander verknüpft, oder er ist tridentat, wenn R eine trivalente Gruppe darstellt, die die Isonitrilgruppen und gegebenenfalls den Liganden L miteinander verknüpft. Höherdentate Liganden sind ebenfalls möglich, wenn L bereits beispielsweise einen bidentaten oder tridentaten Liganden darstellt.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden. Ein cyclisches Carben im Sinne dieser Erfindung ist eine cyclische Gruppe, welche über ein neutrales C-Atom an das Metall bindet. Dabei kann die cyclische Gruppe gesättigt oder ungesättigt sein. Bevorzugt sind hierbei Arduengo-Carbene, also solche Carbene, bei welchen an das Carben-C-Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Erfindung angesehen.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein $sp^3$- oder $sp^2$-hybridisiertes C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl oder Alkinylgruppe oder durch eine Silylgruppe unterbrochen sind.

Unter einer cyclischen Alkyl-, Alkenyl, Alkinyl, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, bevorzugt die Reste Methyl, Ethyl, *n*-Propyl, *i*-Propyl, *n*-Butyl, *i*-Butyl, *s*-Butyl, *t*-Butyl, 2-Methylbutyl, *n*-Pentyl, *s*-Pentyl, *tert*-Pentyl, 2-Pentyl, Cyclopentyl, *n*-Hexyl, *s*-Hexyl, *tert*-Hexyl, 2-Hexyl, 3-Hexyl, Cyclohexyl, 2-Methylpentyl, *n*-Heptyl, 2-Heptyl, 3-Heptyl, 4-Heptyl, Cycloheptyl, 1-Methylcyclohexyl, *n*-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer $C_1$- bis $C_{40}$-Alkoxygruppe werden bevorzugt Methoxy, Trifluormethoxy, Ethoxy, *n*-Propoxy, *i*-Propoxy, *n*-Butoxy, *i*-Butoxy, *s*-Butoxy, *t*-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4, 5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden die Ausführungsformen der Verbindung gemäß Formel (1) beschrieben, wie sie bevorzugt in der elektronischen Vorrichtung verwendet werden.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Liganden L und des Restes R am Isonitrilliganden so gewählt wird, dass sie die Ladung des komplexierten Metallatoms M kompensiert.

Bevorzugt sind weiterhin Verbindungen gemäß Formel (1), dadurch gekennzeichnet, dass die Summe der Valenzelektronen um das Metallatom in fünfach koordinierten Komplexen 16 und in sechsfach koordinierten Komplexen 18 beträgt. Diese Bevorzugung ist durch die besondere Stabilität dieser Metallkomplexe begründet (siehe z. B. Elschenbroich, Salzer, Organometallchemie, Teubner Studienbücher, Stuttgart 1993).

Bevorzugt sind Verbindungen gemäß Formel (1), in denen M für ein pentakoordiniertes oder für ein hexakoordiniertes Übergangsmetall steht, besonders bevorzugt ausgewählt aus der Gruppe bestehend aus Chrom, Molybdän, Wolfram, Rhenium, Ruthenium, Osmium, Rhodium, Iridium, Nickel, Platin, Kupfer, Silber und Gold, insbesondere Molybdän, Wolfram, Rhenium, Ruthenium, Osmium, Iridium, Platin und Gold. Die Metalle können dabei in verschiedenen Oxidationsstufen vorliegen. Bevorzugt sind dabei die oben genannten Metalle in den Oxidationsstufen Cr(O), Cr(II), Cr (III), Cr(IV), Cr(VI), Mo(O), Mo(II), Mo(III), Mo(IV), W(O), W(II), W(III), W(IV), Re(I), Re(II), Re(III), Re(IV), Ru(II), Ru(III), Os(II), Os(III), Os(IV), Rh(I), Rh(III), Ir(I), Ir(III), Ir(IV), Ni(0), Ni(II), Ni(IV), Pt(IV), Cu(I), Cu(II), Cu(III), Ag(II), Au(III) und Au(V); ganz besonders bevorzugt sind Mo(0), W(0), Re(I), Ru(II), Os(II), Rh(III), Ir(III) und Pt(IV).

In einer bevorzugten Ausführungsform der Erfindung ist M ein pentakoordiniertes Metall und der Index x steht für 3 oder 5. In einer weiteren bevorzugten Ausführungsform der Erfindung ist M ein hexakoordiniertes Metall und der Index x steht für 3, 4 oder 6.

In einer Ausführungsform der Erfindung sind ein oder mehrere der Isonitrilliganden monodentate Liganden. In diesem Fall steht der Substituent R bevorzugt gleich oder verschieden bei jedem Auftreten für eine geradkettige Alkylgruppe mit 1 bis 20 C-Atomen oder eine verzweigte oder cyclische Alkylgruppe mit 3 bis 20 C-Atomen, die jeweils mit einem oder mehreren Resten $R^1$ substituiert sein kann, wobei eine oder mehrere nicht benachbarte $CH_2$-Gruppen durch $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, oder für ein monovalentes aromatisches oder heteroaromatisches Ringsystem mit 5 bis 40 aromatischen Ringatomen, das jeweils durch einen oder mehrere Reste $R^1$ substituiert sein kann, oder für eine Kombination dieser Systeme. Besonders bevorzugt steht der Substituent R, wenn der Isonitrilligand ein monodentater Ligand ist, bei jedem Auftreten gleich oder verschieden für eine geradkettige Alkylgruppe mit 1 bis 10 C-Atomen oder eine verzweigte oder cyclische Alkylgruppe mit 3 bis 10 C-Atomen, die jeweils mit einem oder mehreren Resten $R^1$ substituiert sein kann, wobei eine oder mehrere nicht benachbarte $CH_2$-Gruppen durch $R^1C=CR^1$, C=C, C=O, C=S oder O ersetzt sein können und wobei ein oder mehrere H-Atome durch D, F oder CN ersetzt sein können, oder für ein monovalentes aromatisches oder heteroaromatisches Ringsystem mit 5 bis 20 aromatischen Ringatomen, das jeweils durch einen oder mehrere Reste $R^1$ substituiert sein kann, oder für eine Kombination dieser Systeme. In einer ganz besonders bevorzugten Ausführungsform der Erfindung ist der Substituent R bei jedem Auftreten gleich oder verschieden ein monovalentes aromatisches oder heteroaromatisches Ringsystem mit 5 bis 20 aromatischen Ringatomen, das jeweils durch einen oder mehrere Reste $R^1$ substituiert sein kann.

Beispiele für monodentate isonitrilliganden sind aliphatische Isonitrile, wie z. B. Methylisonitril, Trifluormethylisonitril, *iso*-Propylisonitril, tert-Butylisonitril, Cyclohexylisonitril oder Adamantylisonitril, oder aromatische Isonitrile, wie z. B. Phenylisonitril, Mesitylisonitril, 2,6-Dimethylphenylisonitril, 2,6-Di-iso-propylphenylisonitril oder 2,6-Di-tert-butylphenylisonitril. Bevorzugt sind aromatische Isonitrile. Wenn R für ein aromatisches oder heteroaromatisches Ringsystem steht, dann ist dieses bevorzugt an mindestens einer Position orthoständig zur Isonitrilgruppe, besonders bevorzugt an beiden Positionen orthoständig zur Isonitrilgruppe durch Substituenten $R^1$ ungleich H substituiert, insbesondere durch Alkylgruppen.

Die Reste R an den Isonitrilgruppen können auch miteinander verknüpft sein und so zusammen mit dem Metall M ein Ringsystem bilden. So können zwei Reste R miteinander verknüpft sein, so dass es sich hier um zweizähnige (bidentate) Isonitrilliganden handelt. Ebenso können drei Reste R miteinander verknüpft sein, so dass es sich hier um dreizähnige (tridentate) Isonitrilliganden handelt. Ebenso ist ganz analog die Bildung von vierzähnigen (tetradentaten), fünfzähnigen (pentadentaten) und sechszähnigen (hexadentaten) Liganden möglich. Ebenso kann der Ligand L an den Rest R am Isonitrilliganden binden und so zusammen mit dem Metall M ein Ringsystem bilden, so dass man zweizähnige Liganden erhält, welche über eine Isonitrilgruppe und eine weitere Gruppe koordinieren. Ganz analog ist die Bildung drei-, vier-, fünf- und sechszähniger Liganden aus den Resten $R^1$ am Liganden L und den Resten R am Isonitril möglich.

In einer bevorzugten Ausführungsform der Erfindung bilden die Substituenten R miteinander und/oder zusammen mit dem Liganden L eine kettenförmige, verzweigte oder mono- oder polycyclische, aliphatische, aromatische und/oder benzoannellierte Struktur und besitzen damit mehrzähnigen bzw. polypodalen Ligandencharakter.

Bevorzugte mehrzähnige Isonitrilliganden, wie sie in Komplexen der Formel (1) verwendet werden können, weisen eine Struktur gemäß Formel (2) oder Formel (3) auf,

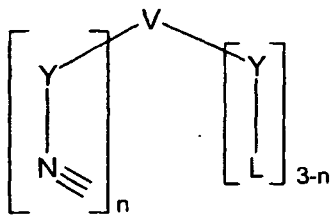

Formel (2)

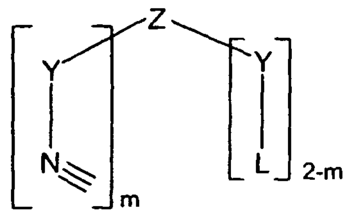

Formel (3)

wobei $R^1$ und L die oben genannten Bedeutungen haben und für die weiteren verwendeten Symbole und Indizes gilt:

Y ist bei jedem Auftreten gleich oder verschieden eine Einfachbindung, O, S, $N(R^1)$, C=O, eine geradkettige Alkylengruppe mit 1 bis 6 C-Atomen oder eine verzweigte oder cyclische Alkylengruppe mit 3 bis 6 C-Atomen, die jeweils mit einem oder mehreren Resten $R^1$ substituiert sein kann, wobei eine oder mehrere nicht benachbarte $CH_2$-Gruppen durch $R^1C=CR^1$, $NR^1$, $Si(R^1)_2$, O oder S ersetzt sein können und wobei ein oder mehrere H-Atome durch D, F, Cl, Br, I, CN oder $NO_2$ ersetzt sein können, oder eine Arylen- oder Heteroarylengruppe mit 5 bis 20 aromatischen Ringatomen, welche mit einem oder mehreren Resten $R^1$ substituiert sein kann, oder eine Kombination dieser Systeme;

V ist B, $B(R^1)$, $CR^1$, $CO^-$, $CN(R^1)_2$, $SiR^1$, N, NO, $N(R^1)^+$, P, $P(R^1)^+$, PO, PS, As, $As(R^1)^+$, AsO, $S^+$, $Se^+$, oder eine Einheit gemäß Formel (4) bis (7),

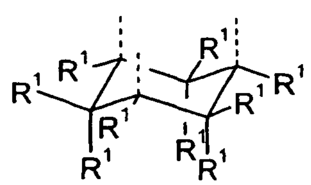

Formel (4)

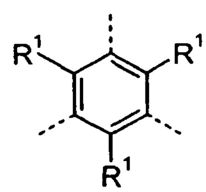

Formel (5)

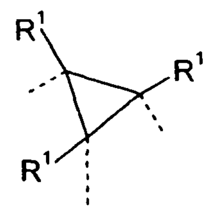

Formel (6)

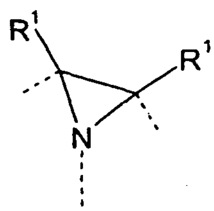

Formel (7)

wobei die gestrichelten Bindungen jeweils die Bindung an Y andeuten;

Z ist $BR^1$, $B(R^1)_2^-$, $C(R^1)_2$, C(=O), $Si(R^1)_2$, $NR^1$, $PR^1$, $P(R^1)_2^+$, $PO(R^1)$, $PS(R^1)$, $AsR^1$, $AsO(R^1)$, AsS, O, S, Se, oder eine Einheit gemäß Formel (8) bis (17),

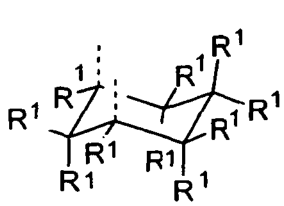

Formel (8)

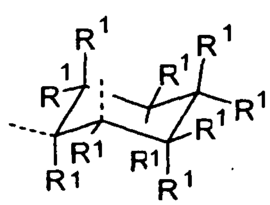

Formel (9)

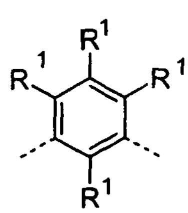

Formel (10)

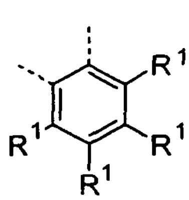

Formel (11)

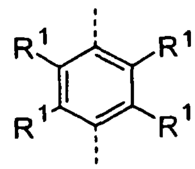

Formel (12)

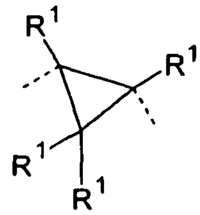

Formel (13)

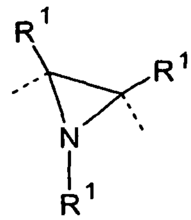

Formel (14)

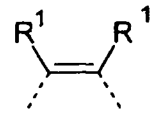

Formel (15)

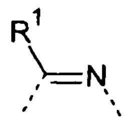

Formel (16)

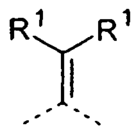

Formel (17)

wobei die gestrichelten Bindungen jeweils die Bindung an Y andeuten;

n ist 1, 2 oder 3, bevorzugt 2 oder 3;
m ist 1 oder 2, bevorzugt 2.

Dabei beträgt die Brückenlänge in den Liganden der Formel (2) bzw. (3) bevorzugt zwischen 6 und 12 Atomen. Unter der Brückenlänge wird die Anzahl der Atome in den beiden Gruppen Y und in der Gruppe V bzw. Z verstanden, die die direkte Verbindung zwischen den Isonitrilgruppen bzw. zwischen der Isonitrilgruppe und der Ligandengruppe L darstellen. Besonders bevorzugt beträgt die Brückenlänge zwischen 7 und 10 Atomen, ganz besonders bevorzugt zwischen 7 und 9 Atomen.

Beispiele für geeignete Liganden sind die in F. E. Hahn et al., J. Organomet. Chem. 1994, 467, 103-111, F. E. Hahn et al., J. Organomet. Chem. 1991, 410, C9-C12, F. E. Hahn et al., Angew. Chem. 1992, 104, 1218-1221, F. E. Hahn et al., Angew. Chem. 1991, 103, 213-215, F. E. Hahn et al., Organometallics 1994, 13, 3002-3008 und F. E. Hahn et al., Organometallics 1992, 11, 84-90 offenbarten polypodalen Isonitrilliganden.

Beispiele für besonders bevorzugte Liganden der Formel (2) und (3) sind die im Folgenden abgebildeten Liganden der Formeln (18) bis (28), welche jeweils durch einen oder mehrere Reste $R^1$ substituiert sein können:

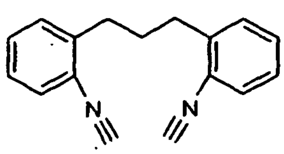

Formel (18)

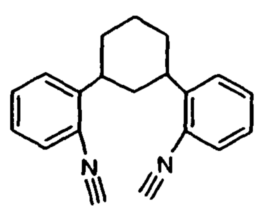

Formel (19)

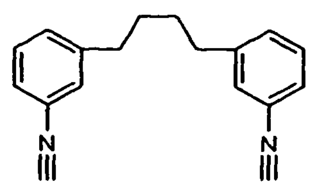

Formel (20)

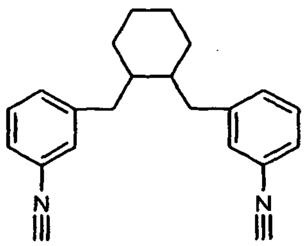

Formel (21)

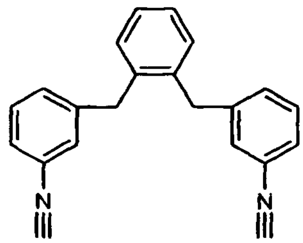

Formel (22)

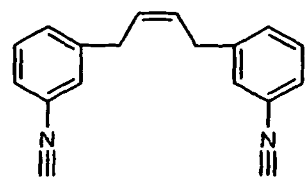

Formel (23)

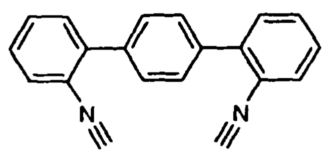

Formel (24)

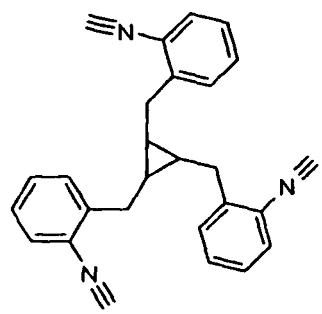

Formel (25)

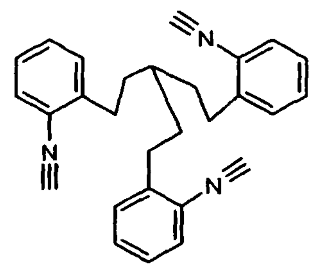

Formel (26)

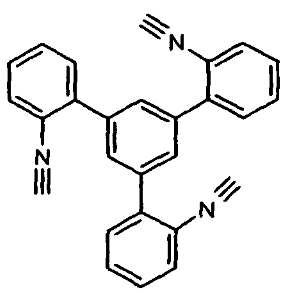

Formel (27)

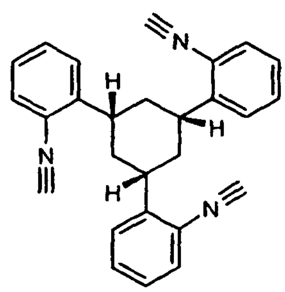

Formel (28)

In einer bevorzugten Ausführungsform der Erfindung ist das Metall M pentakoordiniert und die Verbindung gemäß Formel (1) enthält einen tridentaten Liganden der Formel (2) und einen bidentaten Liganden der Formel (3).

In einer weiteren bevorzugten Ausführungsform der Erfindung ist das Metall M hexakoordiniert und die Verbindung gemäß Formel (1) enthält entweder zwei tridentate Liganden der Formel (2) oder drei bidentate Liganden der Formel (3).

Im Folgenden werden bevorzugte Liganden L beschrieben, wie sie in Formel (1) vorkommen. Entsprechend können auch die Ligandengruppen L in den Liganden der Formel (2) und (3) gewählt sein, wobei diese dann an die Gruppe Y gebunden sind.

Die Liganden L sind bevorzugt neutrale, monoanionische, dianionische oder trianionische Liganden, besonders bevorzugt neutrale oder monoanionische Liganden. Sie können monodentat sein, sind aber bevorzugt bidentat oder tridentat, weisen also bevorzugt zwei oder drei Koordinationsstellen auf. Die Liganden L können auch an den Rest R gebunden sein. Bevorzugte Ausführungsformen sind dabei die oben aufgeführten Liganden der Formel (2) und (3). In Liganden der Formel (2) und (3) ist L bevorzugt ein monodentater oder bidentater Ligand.

Bevorzugte neutrale, monodentate Liganden L sind ausgewählt aus Kohlenmonoxid, Stickstoffmonoxid, Aminen, wie z. B. Trimethylamin, Triethylamin, Morpholin, Phosphinen, insbesondere Halogenphosphinen, Trialkylphophinen, Triarylphosphinen oder Alkylarylphosphinen, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin,

Tris(pentafluorphenyl)arsin, Stibinen, wie z. B. Trifluorstibin, Trimethylstibin, Tricyclohexylstibin, Tri-tert-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L sind ausgewählt aus Hydrid, Deuterid, den Halogeniden F, Cl, Br und I, Alkylacetyliden, wie z. B. Methyl-$C{\equiv}C^-$, tert-Butyl-$C{\equiv}C^-$, Arylacetyliden, wie z. B. Phenyl-$C{\equiv}C^-$, Cyanid, Azid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt $C_1$-$C_{20}$-Alkylgruppen, besonders bevorzugt $C_1$-$C_{10}$-Alkylgruppen, ganz besonders bevorzugt $C_1$-$C_4$-Alkylgruppen. Unter einer Arylgruppe werden auch Heteroarylgruppen verstanden. Diese Gruppen sind wie oben definiert.

Bevorzugte di- bzw. trianionische Liganden sind $O^{2-}$, $S^{2-}$, Carbide, welche zu einer Koordination der Form R-C≡M führen, und Nitrene, welche zu einer Koordination der Form R-N=M führen, wobei R allgemein für einen Substituenten steht, oder $N^{3-}$.

Bevorzugte neutrale oder mono- oder dianionische bidentate oder höherdentate Liganden L sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[(1-(Phenylimino)ethyl]pyridin, 2-[1-(2-Methylphenylimino)ethyl]pyridin, 2-[1-(2,6-Di-*iso*-propylphenylimino) ethyl]pyridin, 2-[1-(Methylimino)ethyl]pyridin, 2-[1-(Ethylimino)ethyl]pyridin, 2-[1-(*iso*-Propylimino)ethyl]pyridin, 2-[1-(*tert*-Butylimino)ethyl]pyridin, Diiminen, wie z. B. 1,2-Bis(methylimino)ethan, 1,2-Bis(ethylimino)ethan, 1,2-Bis (*iso*-propylimino)ethan, 1,2-Bis(*tert*-butyl-imino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino) ethan, 1,2-Bis(2,6-di-*iso*-propylphenyl-imino)ethan, 1,2-Bis(2,6-di-*tert*-butylphenylimino)ethan, 2,3-Bis(phenyl-imino) butan, 2,3-Bis(2-methylphenylimino)butan, 2,3-Bis(2,6-di-*iso*-propyl-phenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis-(diphenylphosphino)methan, Bis-(diphenylphosphino)ethan, Bis(diphenylphosphino)propan, Bis-(diphenylphosphino)butan, Bis(dimethylphosphino)methan, Bis(dimethylphosphino)ethan, Bis(dimethylphosphino)propan, Bis(dimethylphosphino)butan, Bis(diethylphosphino)methan, Bis(diethylphosphino)ethan, Bis(diethylphosphino)propan, Bis (diethyl-phosphino)butan, Bis(di-*tert*-butylphosphino)methan, Bis(di-*tert*-butyl-phosphino)ethan, Bis(*tert*-butylphosphino)propan, Bis(di-*tert*-butylphosphino)butan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden sind Borate stickstoffhaltiger Heterocyclen, wie z. B. Tetrakis(1-imidazolyl) borat und Tetrakis(1-pyrazolyl)borat.

Bevorzugt sind weiterhin bidentate monoanionische Liganden L, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste $R^1$ substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L für Verbindungen gemäß Formel (1) auswählen. Generell eignet sich dafür besonders die Kombination aus zwei Gruppen, wie sie durch die folgenden Formeln (29) bis (56) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand L kann dann aus den Gruppen der Formeln (29) bis (56) gebildet werden, indem diese Gruppen jeweils an der durch # gekennzeichneten Position aneinander binden. Die Position, an der die Gruppen an das Metall koordinieren, sind durch * gekennzeichnet. In Liganden der Formel (2) oder (3) können auch einzelne dieser Gruppen als Ligand L an die Gruppe Y des Liganden gebunden sein.

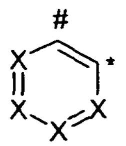

Formel (29)

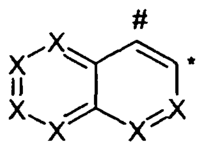

Formel (30)

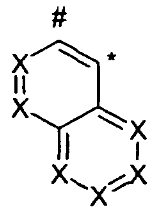

Formel (31)

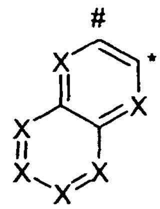

Formel (32)

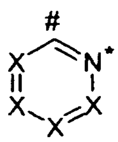

Formel (33)

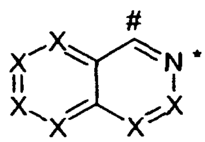

Formel (34)

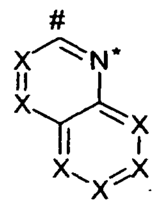

Formel (35)

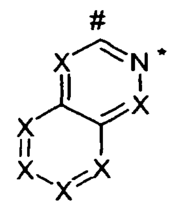

Formel (36)

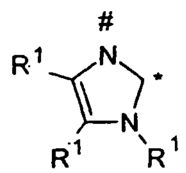

Formel (37)

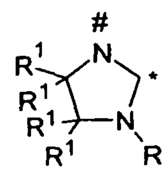

Formel (38)

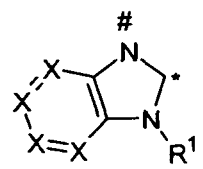

Formel (39)

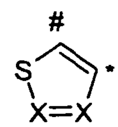

Formel (40)

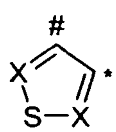

Formel (41)

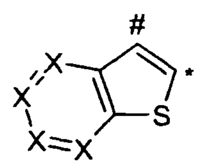

Formel (42)

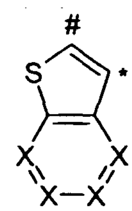

Formel (43)

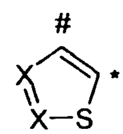

Formel (44)

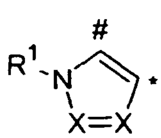

Formel (45)

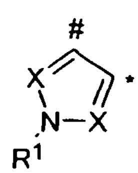

Formel (46)

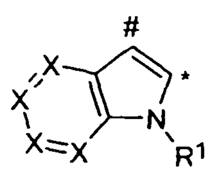

Formel (47)

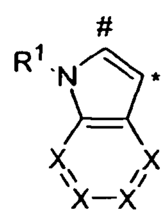

Formel (48)

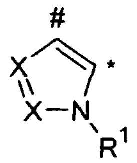
Formel (49)

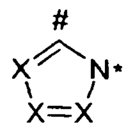
Formel (50)

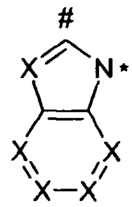
Formel (51)

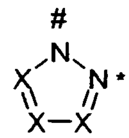
Formel (52)

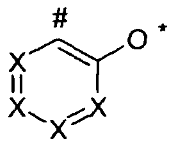
Formel (53)

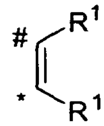
Formel (54)

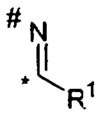
Formel (55)

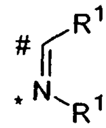
Formel (56)

Dabei haben die verwendeten Symbole dieselbe Bedeutung, wie oben beschrieben, und X steht gleich oder verschieden bei jedem Auftreten für $CR^1$ oder N mit der Maßgabe, dass maximal drei Symbole X in jeder Gruppe für N stehen. Bevorzugt stehen maximal zwei Symbole X in jeder Gruppe für N, besonders bevorzugt steht maximal ein Symbol X in jeder Gruppe für N, ganz besonders bevorzugt stehen alle Symbole X für $CR^1$.

Ebenfalls bevorzugte Liganden L sind $\eta^5$-Cyclopentadienyl, $\eta^5$-Pentamethylcyclopentadienyl, $\eta^6$ -Benzol oder $\eta^7$-Cycloheptatrienyl, welche jeweils durch einen oder mehrere Reste $R^1$ substituiert sein können.

Ebenfalls bevorzugte Liganden L sind 1,3,5-cis-Cyclohexanderivate, insbesondere der Formel (57), 1,1,1-Tri (methylen)methanderivate, insbesondere der Formel (58) und 1,1,1-trisubstituierte Methane, insbesondere der Formel (59) und (60),

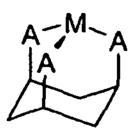
Formel (57)

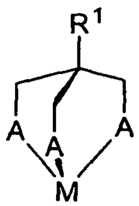
Formel (58)

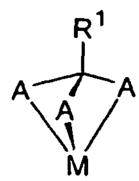
Formel (59)

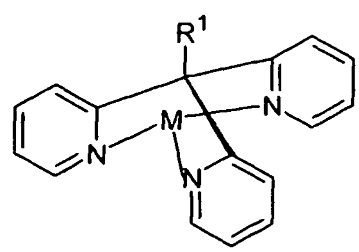
Formel (60)

wobei in den Formeln jeweils die Koordination an das Metall M dargestellt ist, $R^1$ die oben genannte Bedeutung hat und A, gleich oder verschieden bei jedem Auftreten, für $O^-$, $S^-$, $COO^-$, $P(R^1)_2$ oder $N(R^1)_2$ steht.

Die Darstellung der Isonitrilkomplexe kann z. B. durch Substitutionsreaktion erfolgen. Dabei werden Metallkomplexe mit den Isonitrilliganden, gegebenenfalls in Gegenwart eines Katalysators, zu den gewünschten Isonitrilkomplexen umgesetzt. Auf diesem Wege sind z. B. ausgehend von Molybdän- bzw. Wolframhexacarbonyl oder Molybdän- bzw. Wolframolefin-carbonylkomplexen Tri-, Tetra-, Penta- und Hexaisonitril-Molybdän bzw. Wolfram-Verbindungen zugänglich. Dieser Reaktionstyp eignet sich sowohl zur Umsetzung von einzähnigen als auch mehrzähnigen Isonitrilliganden. Als Katalysator kann Palladium(II)oxid zugesetzt werden (Albers et al., J. Chem. Edu. 1986, 63(5), 444; Coville et al. Inorg. Chim. Acta 1982, 65, L7-L8; Yamamoto et al., J. Organomet. Chem. 1985, 282, 191, Hahn et al., Organometallics 1994, 13, 3002; F. Hahn et al., Organometallics 1992, 11, 84).

$$M(CO)_6 \quad + \quad n\ R\text{-}NC \xrightarrow{PdO} M(CO)_{6-n}(CN\text{-}R)_n$$

$$M = Mo, W \qquad n = 3, 4, 5, 6$$

Daneben können Metallsalze mit Isonitrilliganden zu Isonitril-Metallhalogeniden umgesetzt werden und die Halogenidliganden in diesen anschließend gegen andere ein- oder mehrzähnige Liganden ausgetauscht werden.

$$IrCl_3 + R\text{-}NC \rightarrow (R\text{-}NC)_3IrCl_3$$

$$(R\text{-}NC)_3IrCl_3 + 3L^- \rightarrow (R\text{-}NC)_3IrL_3 + 3Cl^-$$

Dabei können sowohl der Isonitrilligand als auch der Ligand L ein- oder mehrzähnig sein.

Beispiele für bevorzugte Verbindungen gemäß Formel (1) sind die im Folgenden abgebildeten Strukturen (1) bis (98).

| | | |
|---|---|---|
| 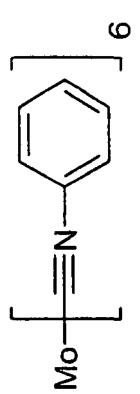 | 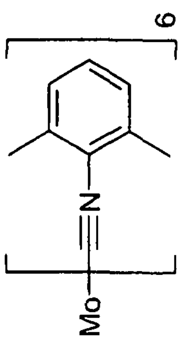 | 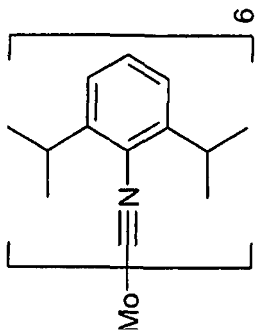 |
| (1) | (2) | (3) |
| 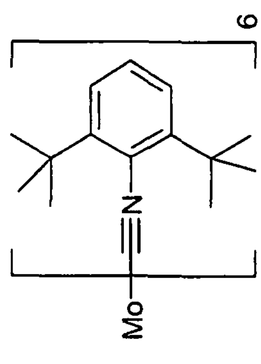 | 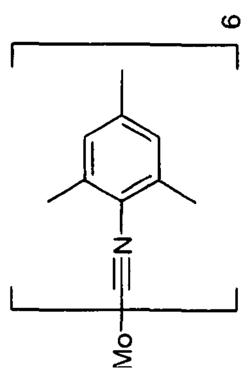 | 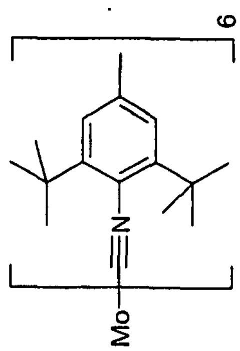 |
| (4) | (5) | (6) |
| 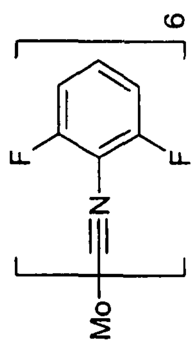 | 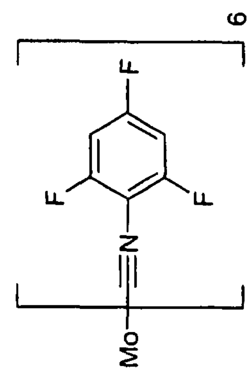 | 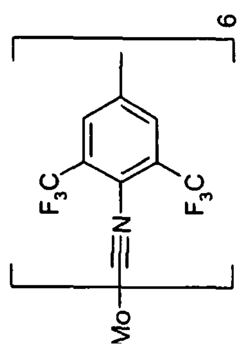 |
| (7) | (8) | (9) |

(fortgesetzt)

| | | |
|---|---|---|
| 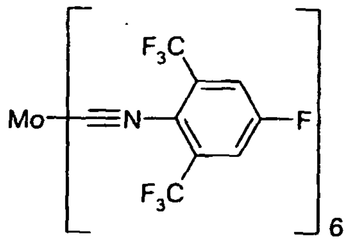 | 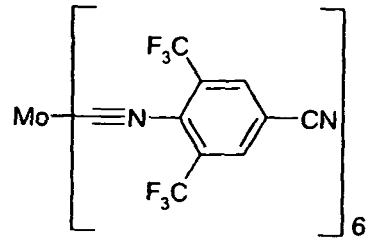 | 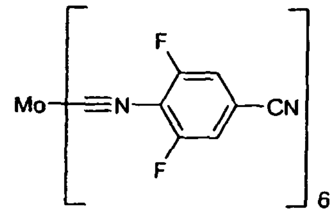 |
| (10) | (11) | (12) |
| 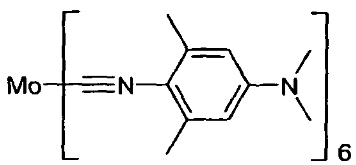 | 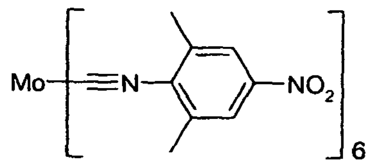 | 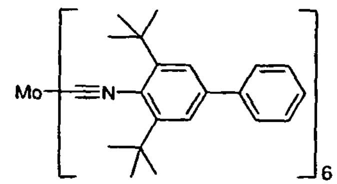 |
| (13) | (14) | (15) |
| 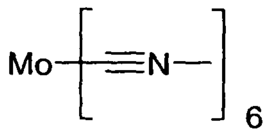 | 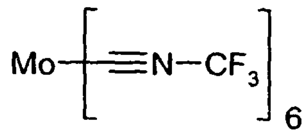 | 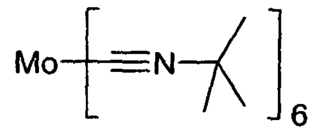 |
| (16) | (17) | (18) |
| 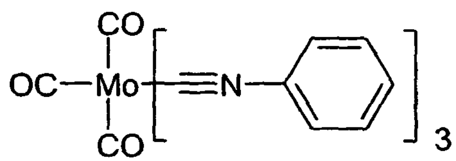 | 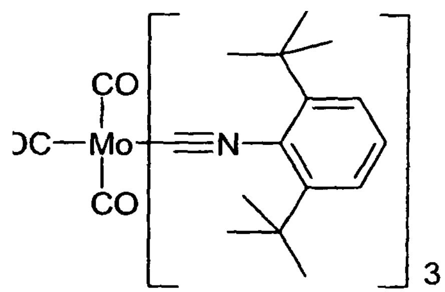 | |
| (19) | (20) | |

(fortgesetzt)

| | |
|---|---|
| 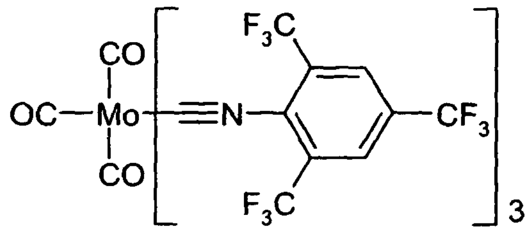 | 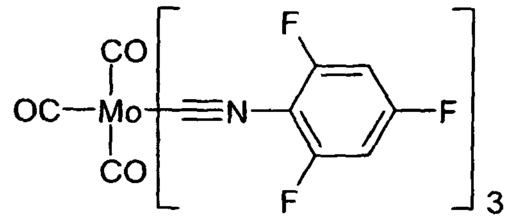 |
| (21) | (22) |
| 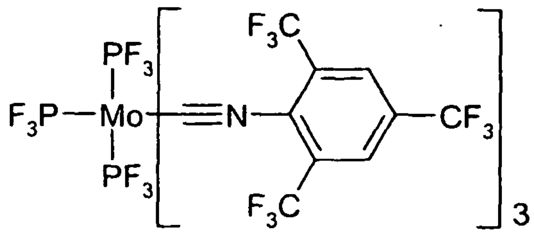 | 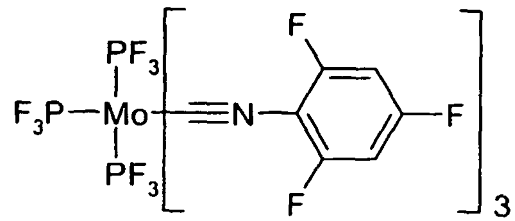 |
| (23) | (24) |
| 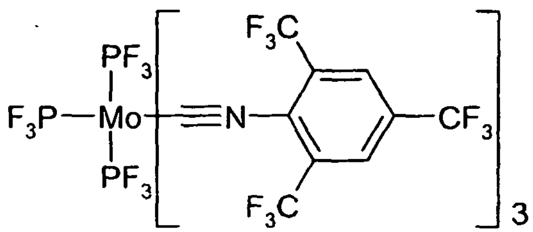 | 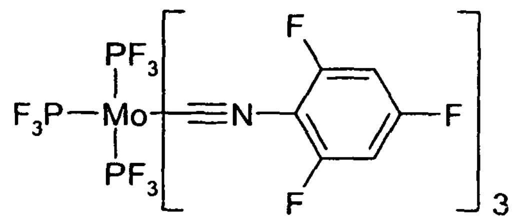 |
| (25) | (26) |
| 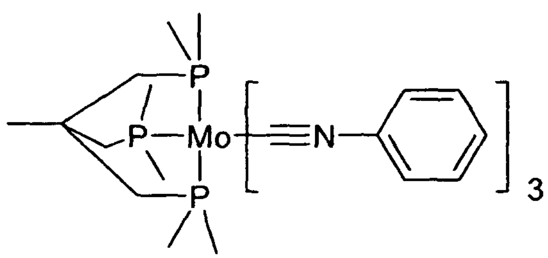 | 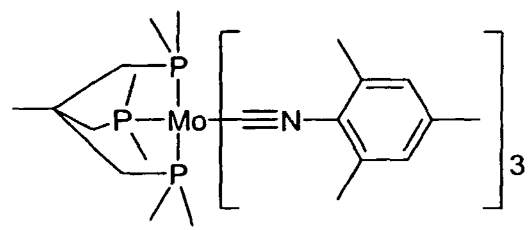 |

(fortgesetzt)

| (27) | (28) |
|---|---|
| 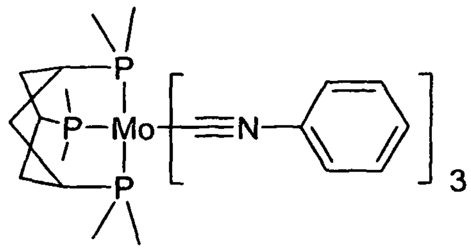 | 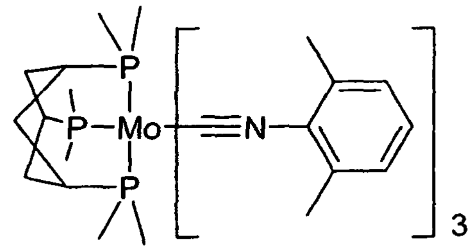 |
| (29) | (30) |
| 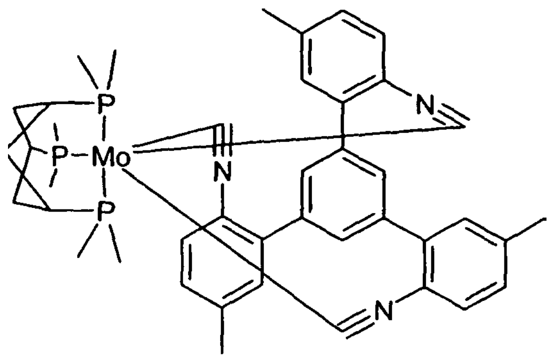 | 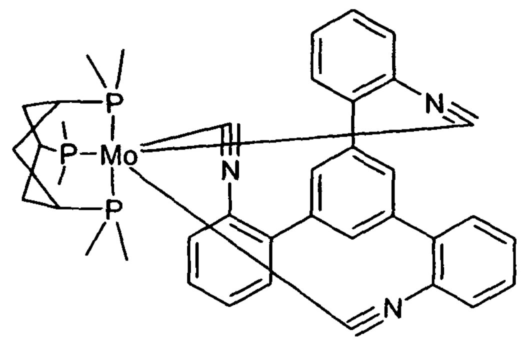 |
| (31) | (32) |

(fortgesetzt)

| | |
|---|---|
| 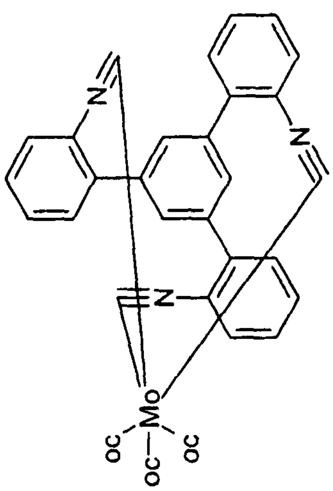 | 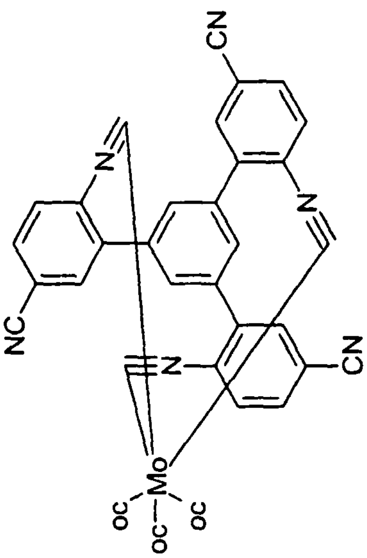 |
| (33) | (34) |
| 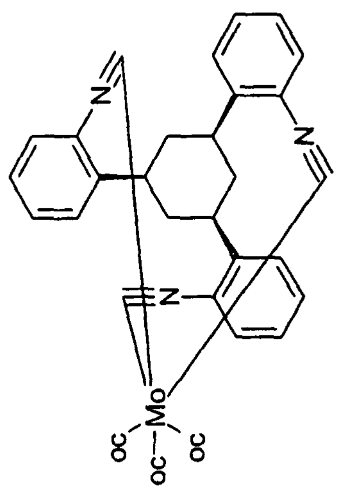 | 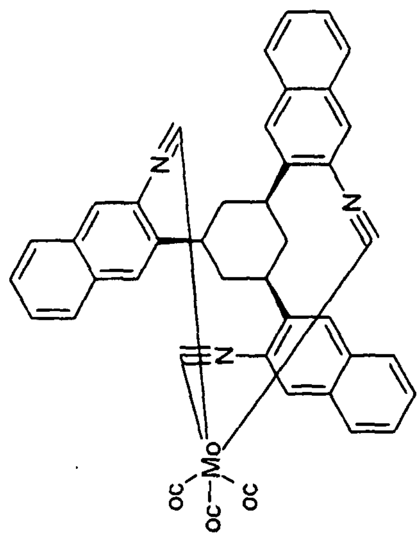 |
| (35) | (36) |

(fortgesetzt)

| | |
|---|---|
| 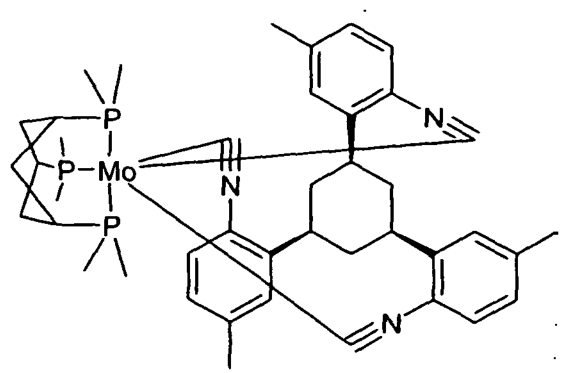 | 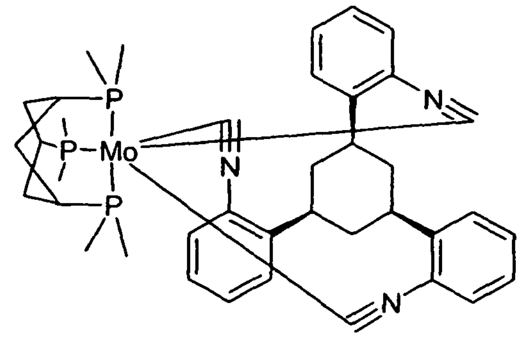 |
| (37) | (38) |

| | | |
|---|---|---|
| 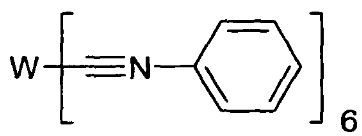 | 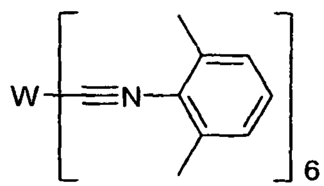 | 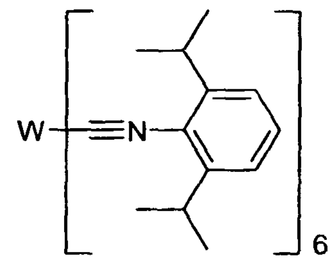 |
| (39) | (40) | (41) |
| 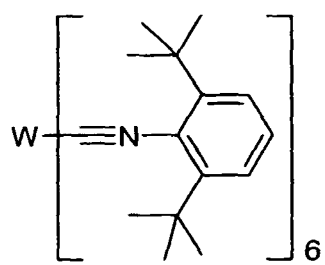 | 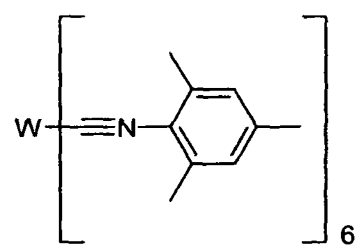 | 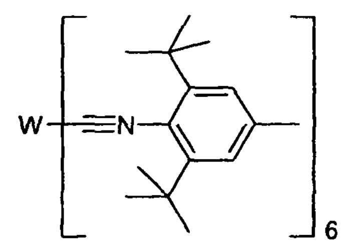 |
| (42) | (43) | (44) |

(fortgesetzt)

| | | |
|---|---|---|
| 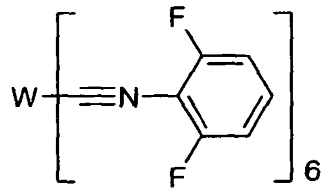 | 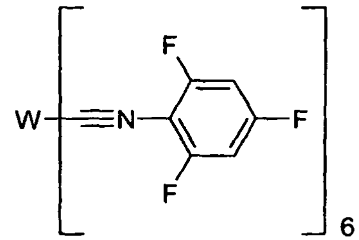 | 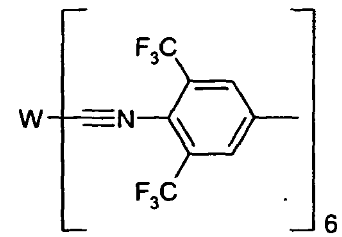 |
| (45) | (46) | (47) |
| 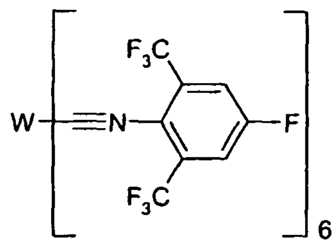 | 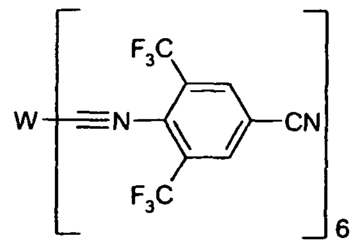 | 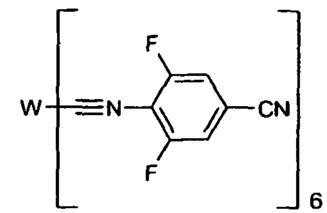 |
| (48) | (49) | (50) |
| 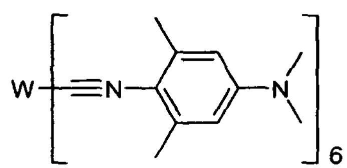 | 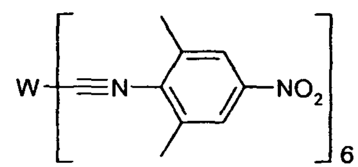 | 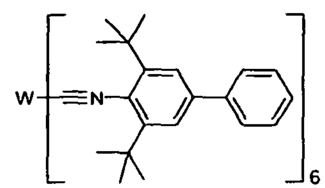 |
| (51) | (52) | (53) |
| 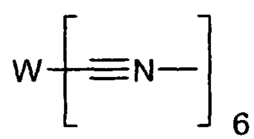 | 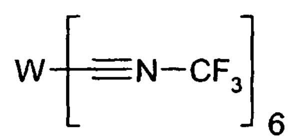 | 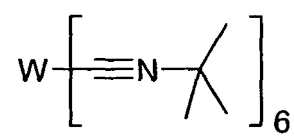 |
| (54) | (55) | (56) |

(fortgesetzt)

| | |
|---|---|
| 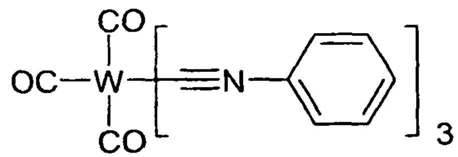 | 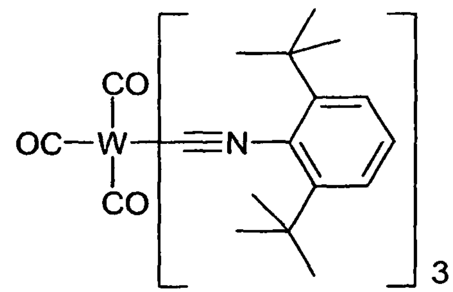 |
| (57) | (58) |
| 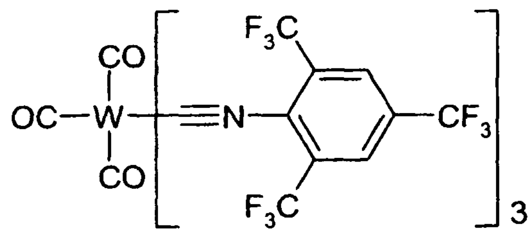 | 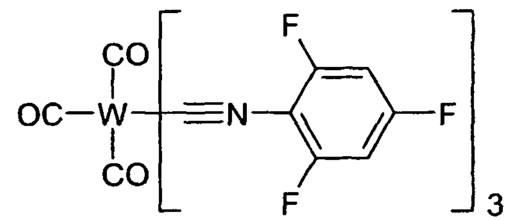 |
| (59) | (60) |
| 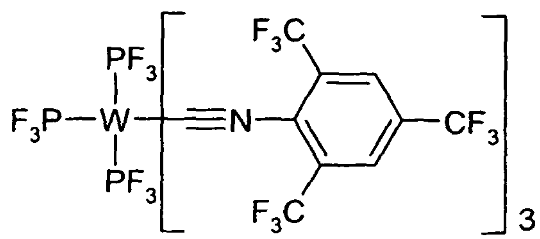 | 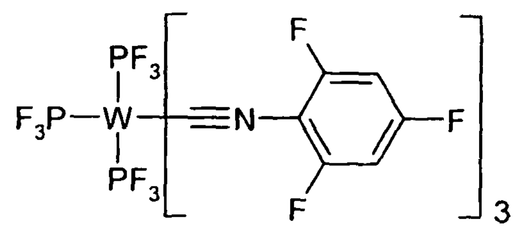 |
| (61) | (62) |

(fortgesetzt)

| | |
|---|---|
| 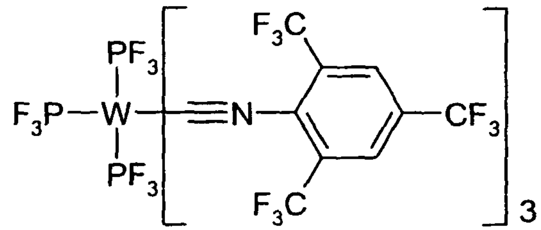 | 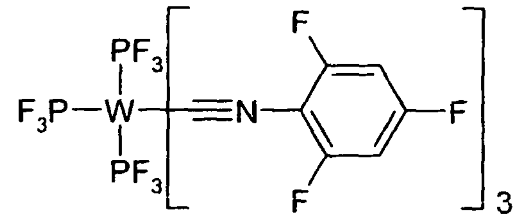 |
| (63) | (64) |
| 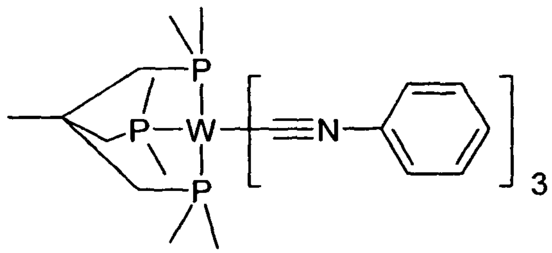 | 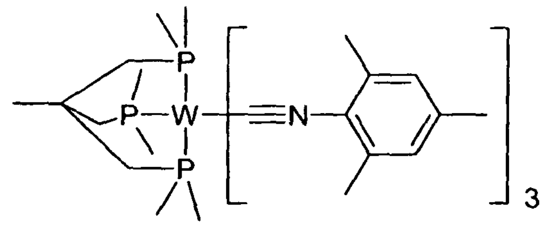 |
| (65) | (66) |
| 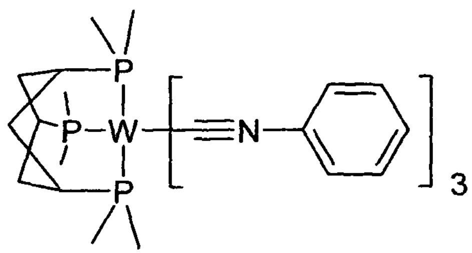 | 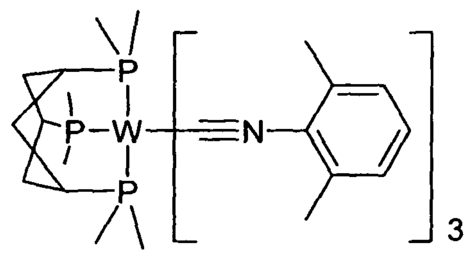 |
| (67) | (68) |

(fortgesetzt)

| | |
|---|---|
| 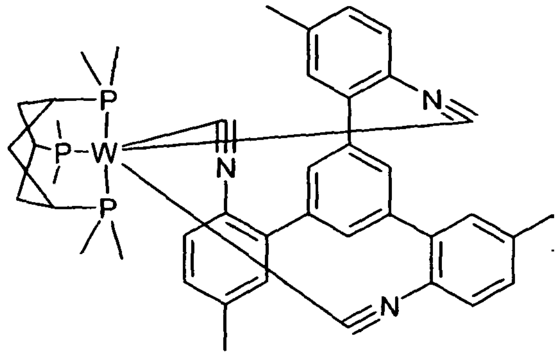 | 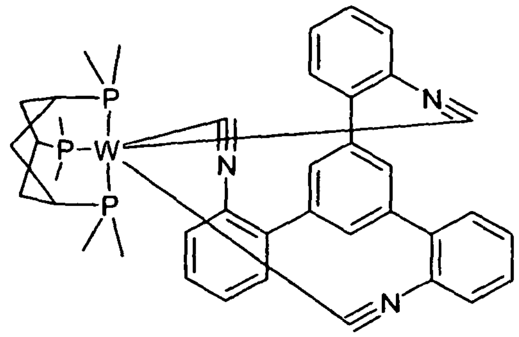 |
| (69) | (70) |
| 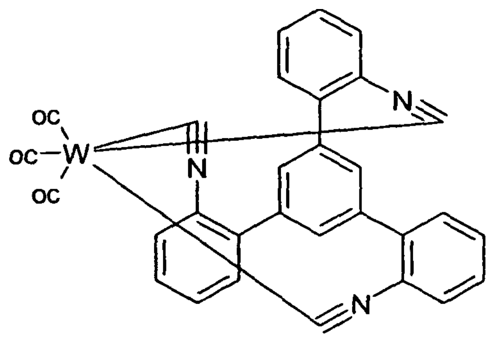 | 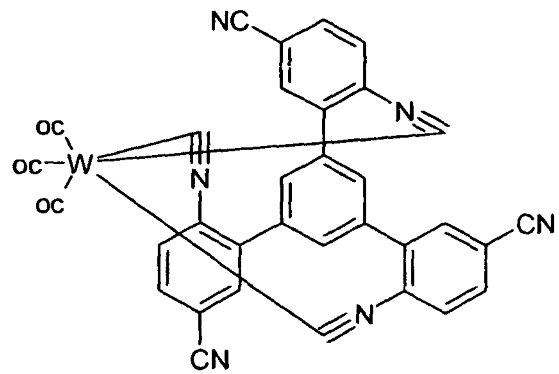 |
| (71) | (72) |

(fortgesetzt)

| | |
|---|---|
| 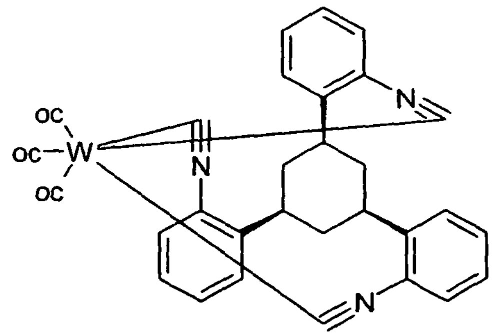 | 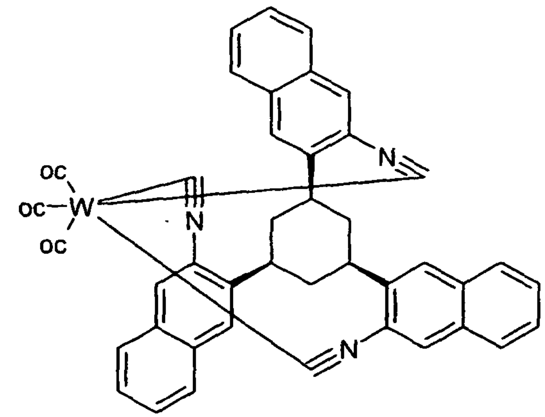 |
| (73) | (74) |
| 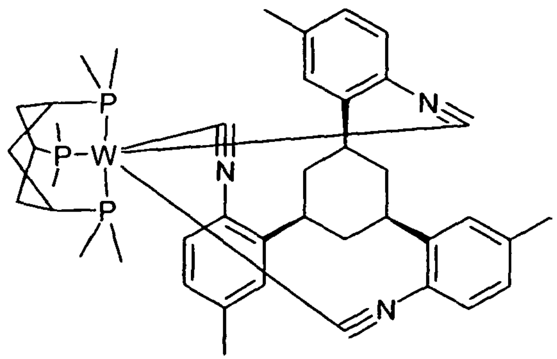 | 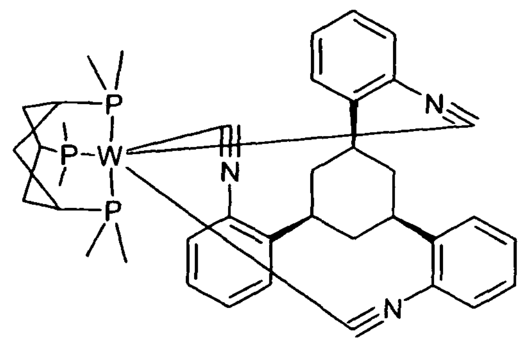 |
| (75) | (76) |

(fortgesetzt)

| | |
|---|---|
| 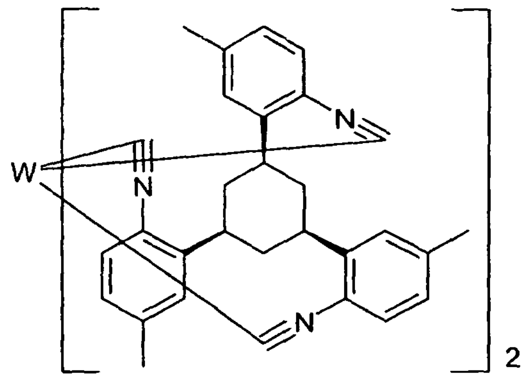 | 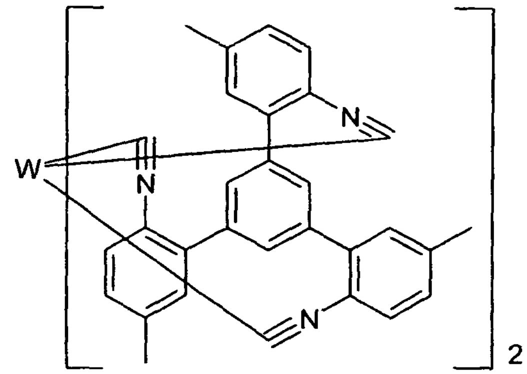 |
| (77) | (78) |
| 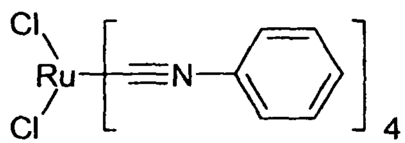 | 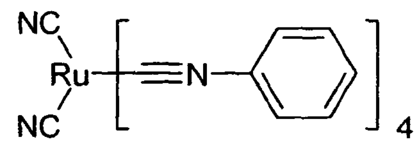 |
| (79) | (80) |
| 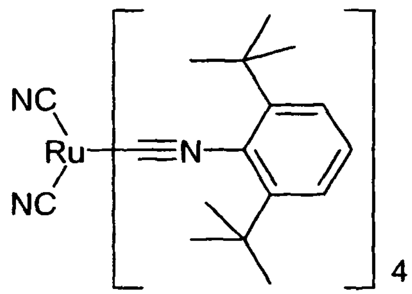 | 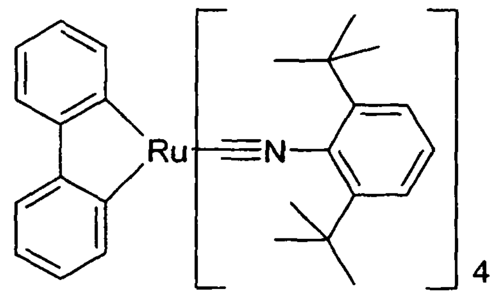 |
| (81) | (82) |

(fortgesetzt)

| | |
|---|---|
| 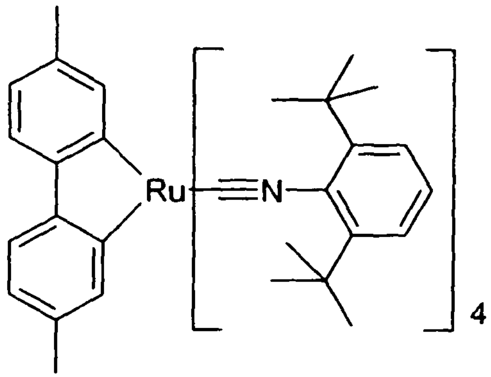 | 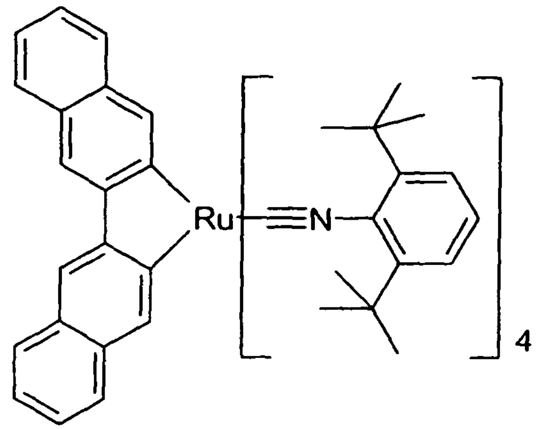 |
| (83) | (84) |
| 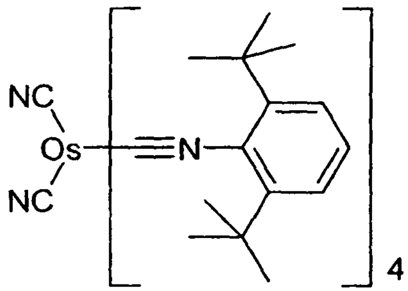 | 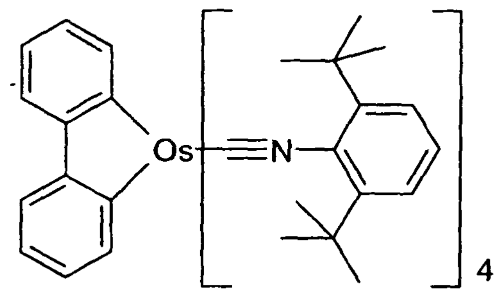 |
| (85) | (86) |

(fortgesetzt)

| | |
|---|---|
| 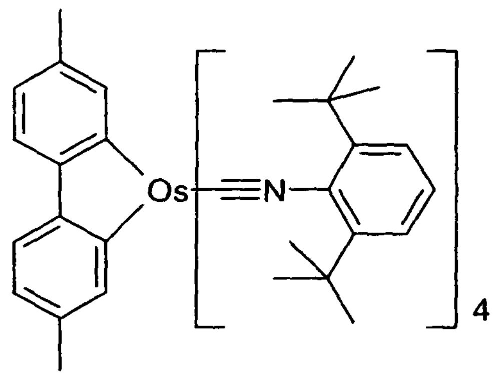 | 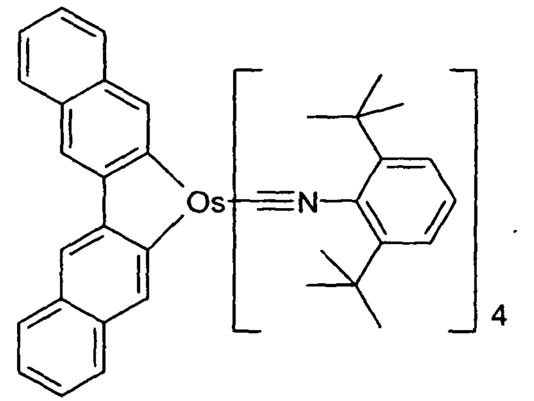 |
| (87) | (88) |
| 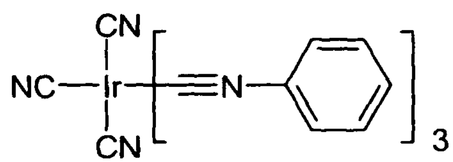 | 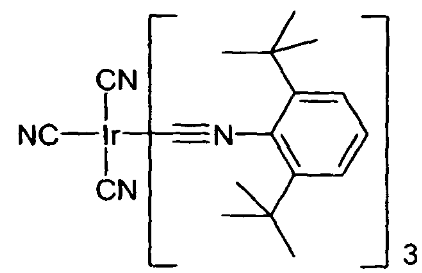 |
| (89) | (90) |
| 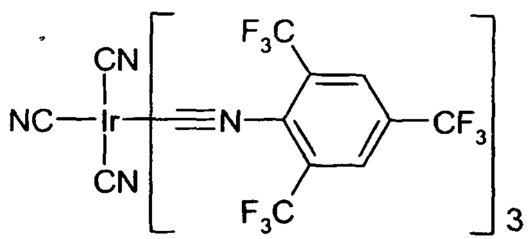 | 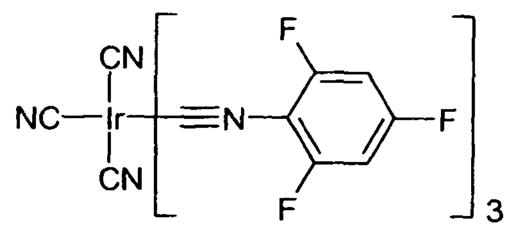 |
| (91) | (92) |

(fortgesetzt)

| | | | |
|---|---|---|---|
| 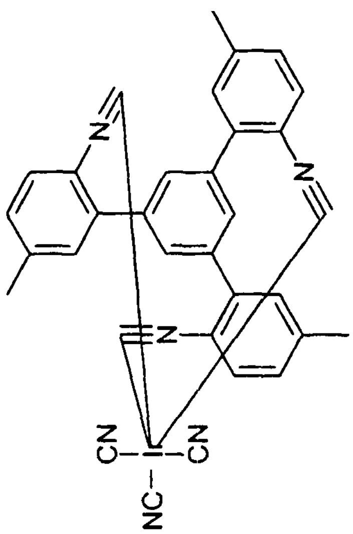 | (93) | 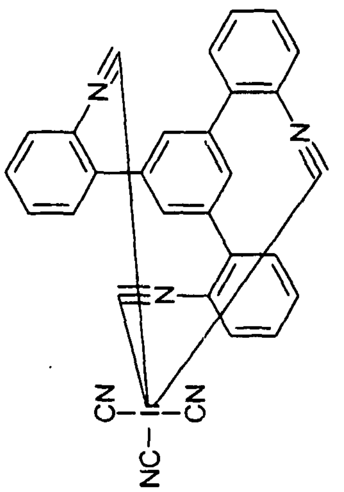 | (94) |
| 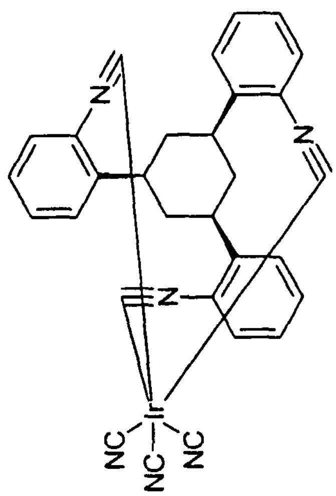 | (95) | 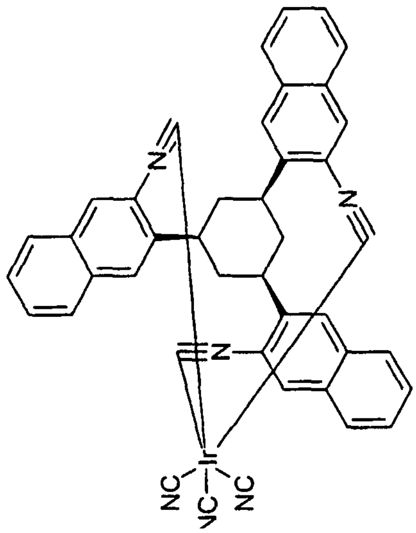 | (96) |

(fortgesetzt)

| | |
|---|---|
| 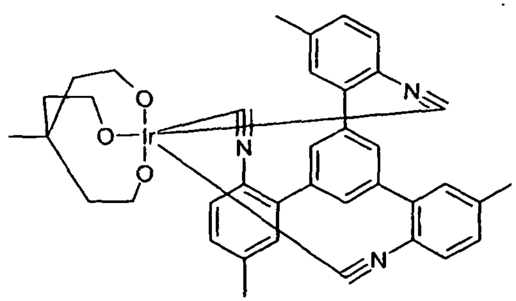 | 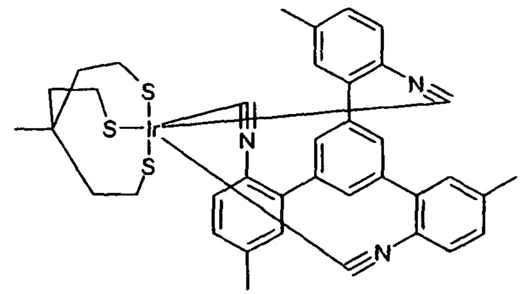 |
| (97) | (98) |

Die oben beschriebenen Komplexe gemäß Formel (1) bzw. die oben aufgeführten bevorzugten Ausführungsformen werden in der elektronischen Vorrichtung als aktive Komponente verwendet. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Für diese Funktionen zeigen die erfindungsgemäßen Verbindungen besonders gute Eigenschaften, insbesondere als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Ladungserzeugungsschichten und/oder organische oder anorganische p/n-Übergänge. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013) bzw. Systeme, welche mehr als drei emittierende Schichten aufweisen.

In einer bevorzugten Ausführungsform der Erfindung enthält die organische elektronische Vorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Bevorzugte Matrixmaterialien sind CBP (N,N-Biscarbazolylbiphenyl), Carbazolderivate (z. B. gemäß WO 05/039246, US 2005/0069729, JP 2004/288381, EP 1205527 oder WO 08/086851, Azacarbazole (z. B. gemäß EP 1617710, EP 1617711, EP 1731584, JP 2005/347160), Ketone (z. B. gemäß WO 04/093207 oder der nicht offengelegten Anmeldung DE 102008033943.1), Phosphinoxide, Sulfoxide und Sulfone (z. B. gemäß WO 05/003253), Oligophenylene, aromatische Amine (z. B. gemäß US 2005/0069729), bipolare Matrixmaterialien (z. B. gemäß WO 07/137725), Silane (z. B. gemäß WO 05/111172), 9,9-Diarylfluorenderivate (z. B. gemäß der nicht offen gelegten Anmeldung DE 102008017591.9), Azaborole, Boronester (z. B. gemäß WO 06/117052), Indolocarbazole (WO 07/063754, WO 08/056746), Triazinderivate (WO 07/063754 oder nicht offengelegte Anmeldung DE 102008036982.9), Zinkkomplexe (EP 652273 oder nicht offengelegte Anmeldung DE 102007053771.0).

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. Da die Verbindungen gemäß Formel (1) im Allgemeinen eine hohe Löslichkeit in organischen Lösemitteln aufweisen, können diese Verbindungen gut aus Lösung verarbeitet werden. So ist es beispielsweise möglich, eine emittierende

Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Metallkomplexe, welche die oben aufgeführten Liganden der Formel (27) und/oder (28) enthalten, sind neu und sind daher ebenfalls ein Gegenstand der vorliegenden Erfindung.

Ein weiterer Gegenstand der Erfindung sind daher Metallkomplexe der Formel (1'),

$$(L)_y\ M\text{-}[C{\equiv}N\text{-}R]_x \qquad \text{Formel (1')}$$

wobei die verwendeten Symbole und Indizes die oben genannten Bedeutungen haben und mindestens einer der Isonitrilliganden ausgewählt ist aus Liganden der Formel (27) oder (28), welcher jeweils auch durch einen oder mehrere Reste $R^1$ substituiert sein kann:

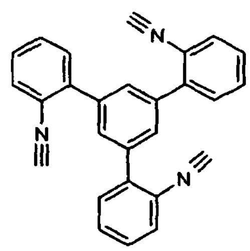

Formel (27)

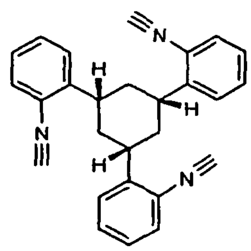

Formel (28)

Dabei gelten in Komplexen der Formel (1') für die Auswahl der Metalle und gegebenenfalls vorhandener weiterer Liganden dieselben Bevorzugungen, wie oben beschrieben.

Für das Aufbringen aus Lösung sind Lösungen der Verbindungen gemäß Formel (1') erforderlich. Weiterer Gegenstand der Erfindung sind daher Lösungen enthaltend mindestens eine Verbindung gemäß Formel (1') und mindestens ein organisches Lösungsmittel, bevorzugt ausgewählt aus der Klasse der aromatischen organischen Lösungsmittel, z. B. Dimethylanisol. Nochmals ein weiterer Gegenstand der Erfindung sind Liganden der oben abgebildeten Formeln (27) und (28), welche jeweils durch einen oder mehrere Reste $R^1$ substituiert sein können.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:

1. Organische Elektrolumineszenzvorrichtungen enthaltend Verbindungen gemäß Formel (1) als emittierende Materialien weisen eine exzellente Lebensdauer auf.

2. Organische Elektrolumineszenzvorrichtungen enthaltend Verbindungen gemäß Formel (1) als emittierende Materialien weisen eine hervorragende Effizienz auf.

3. Die Lumineszenzlebensdauer vieler Verbindungen gemäß Formel (1) bei Raumtemperatur liegt im Bereich von weniger als 100 ns und ist damit um mehr als eine Größenordnung geringer als die Lumineszenzlebensdauer von Iridiumkomplexen oder Platinkomplexen, wie sie gemäß dem Stand der Technik in organischen Elektrolumineszenzvorrichtungen eingesetzt werden. Daher eignen sich die Verbindungen gemäß Formel (1) insbesondere auch zum Einsatz in organischen

Elektrolumineszenzvorrichtungen mit Passiv-Matrix-Ansteuerung. Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen.

**Beispiele:**

**Beispiele 1 bis 9: Synthese der Metallkomplexe**

Die nachfolgenden Synthesen werden, sofern nicht anders angegeben, unter einer Schutzgasatmosphäre in getrockneten Lösungsmitteln durchgeführt. Die Lösungsmittel und Reagenzien können von ALDRICH bzw. ABCR bezogen werden.

Hexakis(phenylisonitril)molybdän(0) (Beispiel 1), Hexakis(phenylisonitril)-wolfram(0) (Beispiel 2) und Hexakis (2,4,6-tri-tert-butylphenylisonitril)-wolfram(0) (Beispiel 3) können nach Albers et al., J. Chem. Edu. 1986, 63(5), 444, Coville et al., Inorg. Chim. Acta 1982, 65, L7-L8, bzw. Yamamoto et al., J. Organomet. Chem. 1985, 282, 191 hergestellt werden. Die Verbindungen werden mehrfach aus Toluol / Ethanol (1:2 - 1:1) umkristallisiert. Die so erzielten Reinheiten betragen typischerweise > 99.8 % nach $^1$H-NMR.

Beispiel 4: Tris-phenylisonitril-[cis,cis-1,3,5-cyclohexan-triyltris[diphenylphosphin]-P,P',P"]-molybdän (0)

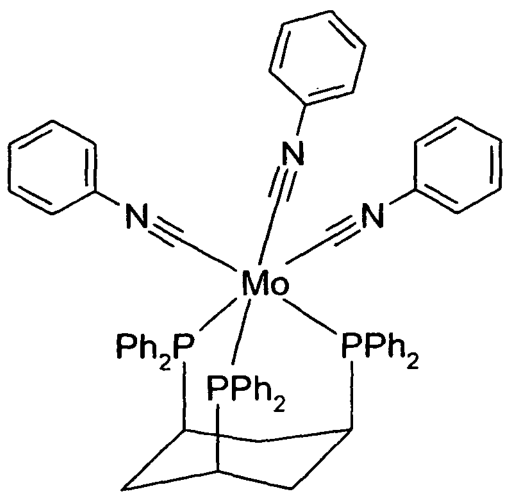

Eine Suspension von 8,2 g [10 mmol] Tricarbonyl[cis,cis-1,3,5-cyclohexan-triyltris[diphenylphosphin]-P,P', P"]-molybdän (0), [156999-20-1] in 100 ml Toluol wird mit 3,6 g (35 mmol) Phenylisonitril und 50 mg Palladium(II)oxid versetzt und anschließend 60 h unter Rückfluss gerührt. Nach Erkalten wird vom Palladium(II)oxid über Kieselgel abfiltriert, die rote Lösung wird im Vakuum auf ca. 10 ml eingeengt und dann mit 50 ml Ethanol versetzt. Nach 12 h Rühren wird der FS abgesaugt, und zweimal aus Toluol / Ethanol umkristallisiert. Ausbeute: 4,3 g, (4,1 mmol), 41,3 %, Reinheit n. $^1$H-NMR ca. 99,7 %.

Analog zu Beispiel 4 wurden die in Tabelle aufgeführten Komplexe aus den entsprechenden Vorstufen dargestellt.

| Bsp. | Vorstufe | Produkt | Ausbeute |
|---|---|---|---|
| 5 | 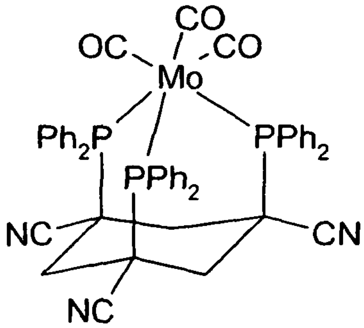 [168280-48-6] | 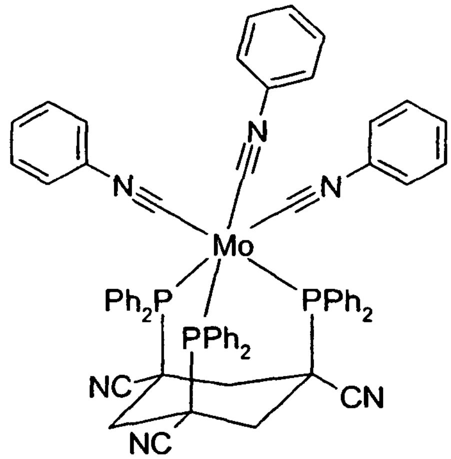 | 38.4% |
| 6 | 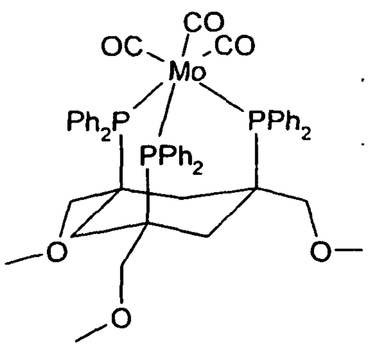 [182130-53-6] | 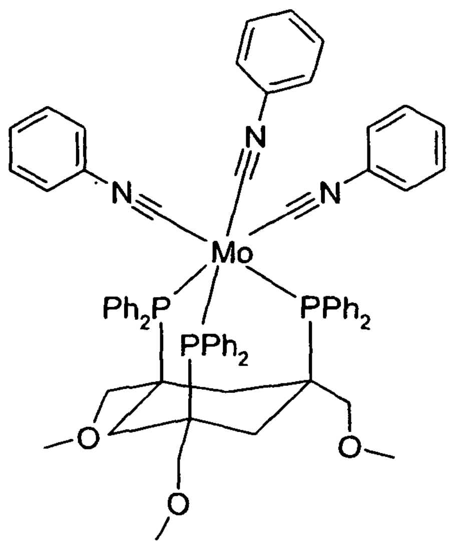 | 41,3% |
| 7 | 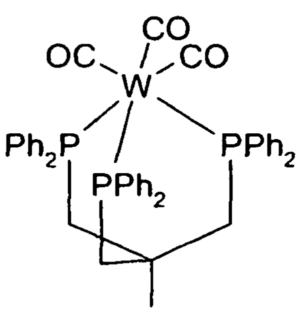 [108270-60-6] | 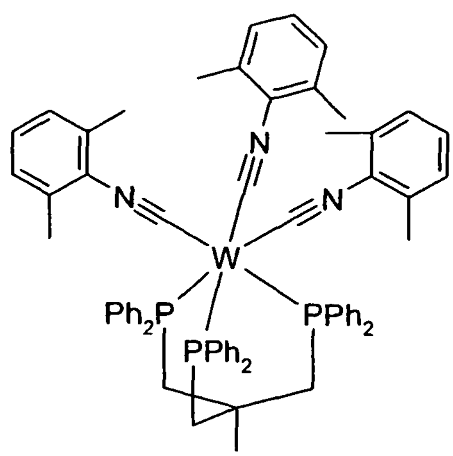 | 34,5% |

Beispiel 8:

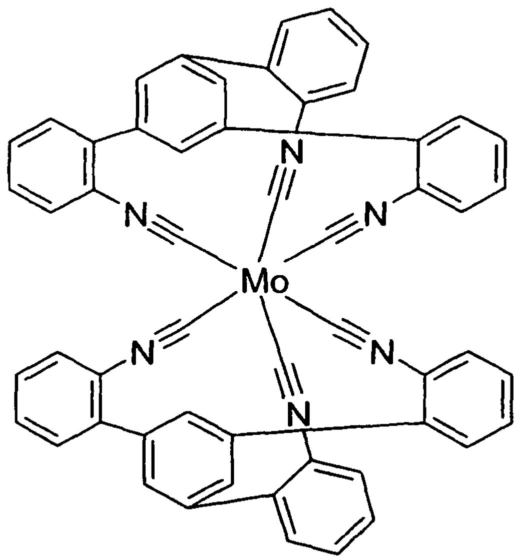

1,3,5-Tris(1-isocyano-phen-2-yl)benzol wird aus 1,3,5-Tris(1-amino-phen-2-yl)benzol [923027-14-9] nach F.E. Hahn et al., J. Organomet. Chem. 467, 130, 1994 dargestellt.

Eine Lösung von 2,6 g [10 mmol] Molybdänhexacarbonyl in 100 ml Toluol wird mit 8,0 g (21 mmol) 1,3,5-Tris (1-isocyanophen-2-yl)benzol und 50 mg Palladium(II)oxid versetzt und anschließend 60 h unter Rückfluss gerührt. Nach Erkalten wird vom Palladium(II)oxid über Kieselgel abfiltriert, die rote Lösung wird im Vakuum auf ca. 10 ml eingeengt und dann mit 50 ml Ethanol versetzt. Nach 12 h Rühren wird der FS abgesaugt, und dann an Aluminiumoxid, neutral, Aktivitätsstufe 4, mit Dichlormethan - Diethylether 1:5 chromatographiert. Ausbeute: 6,1 g, (7.1 mmol), 71.0 %, Reinheit n. $^{1}$H-NMR ca. 99,9 %.

Beispiel 9:

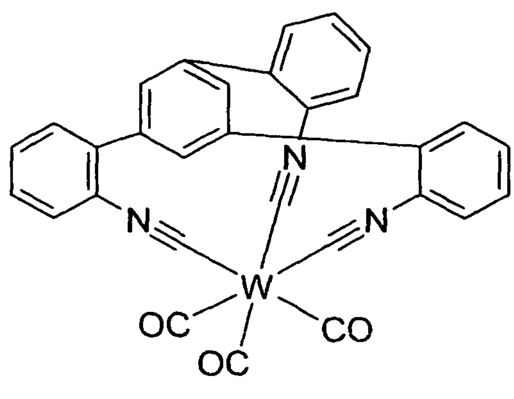

Eine Lösung von 3,6 g [10 mmol] Cycloheptatrienyl-wolfram-tricarbonyl in 100 ml Toluol wird mit 4,2 g (11 mmol) 1,3,5-Tris(1-isocyanophen-2-yl)benzol versetzt und anschließend 5 h unter Rückfluss gerührt. Nach Erkalten wird im Vakuum auf ca. 10 ml eingeengt und dann mit 50 ml Heptan versetzt, der ausgefallene Feststoff wird abgesaugt, dreimal mit 50 ml Heptan gewaschen und zweimal aus Chlorbenzol umkristallisiert. Ausbeute: 4,8 g, (7,4 mmol), 73,9 %, Reinheit n. $^{1}$H-NMR ca. 99,9 %.

**Beispiel 10: Lumineszenzlebensdauer der Komplexe**

Die Isonitrilkomplexe weisen die folgenden Lumineszenzlebensdauern bei Raumtemperatur auf (nach: K. Mann et al., J. Am. Chem. Soc. 1977, 99(1),306):

Hexakis(phenylisonitril)molybdän(0) (Beispiel 1) = 43 ns;
Hexakis(phenylisonitril)wolfram(0) (Beispiel 2) = 83 ns.

Hieraus lässt sich deutlich erkennen, dass die Metallkomplexe der Formel (1) mit Isonitrilliganden eine deutlich geringere Lumineszenzlebensdauer aufweisen als Iridium- oder Platinkomplexe, wie sie gemäß dem Stand der Technik meist in OLEDs verwendet werden. Damit eignen sich diese Komplexe insbesondere auch zur Anwendung in Elektrolumineszenzvorrichtungen mit Passiv-Matrix-Ansteuerung.

**Beispiel 11: Herstellung und Charakterisierung von organischen Elektrolumineszenzvorrichtungen**

Die Herstellung von LEDs erfolgt nach dem im Folgenden skizzierten allgemeinen Verfahren. Dieses muss natürlich im Einzelfall auf die jeweiligen Gegebenheiten (z. B. Schichtdickenvariation, um optimale Effizienz bzw. Farbe zu erreichen) angepasst werden.

**Allgemeines Verfahren zur Herstellung der OLEDs:**

Die Herstellung solcher Bauteile lehnt sich an die Herstellung polymerer Leuchtdioden (PLEDs) an, die in der Literatur bereits vielfach beschrieben ist (z.B. in der WO 2004/037887 A2). Im vorliegenden Fall werden die erfindungsgemäßen Verbindungen zusammen mit den auf geführten Matrixmaterialien oder Matrixmareialkombinationen in Toluol bzw. Chlorbenzol gelöst. Der typische Feststoffgehalt solcher Lösungen liegt zwischen 10 und 25 g/L, wenn, wie hier, die für eine Device typische Schichtdicke von 80 nm mittels Spincoating erzielt werden soll.
Als Matrixmaterialen werden folgende Verbindungen verwendet:

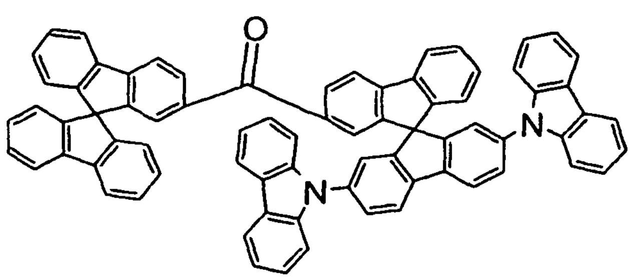

Verbindung 1
[959422-18-5]

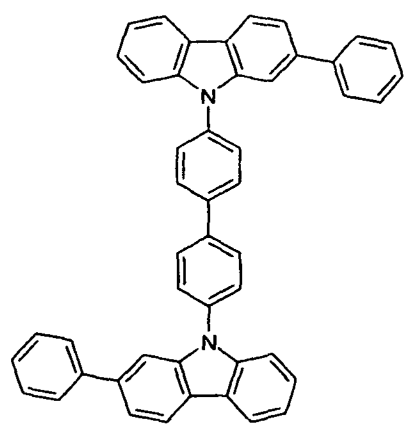

Verbindung 2
[1040882-55-0]

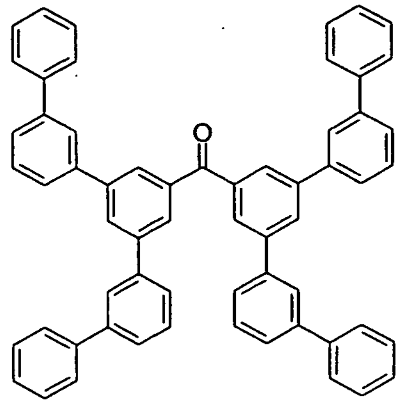

Verbindung 3
DE102008033943.1

Analog dem o. g. allgemeinen Verfahren werden OLEDs mit folgendem Aufbau erzeugt:

| | |
|---|---|
| PEDOT | 20 nm (aus Wasser aufgeschleudert; PEDOT bezogen von BAYER AG; Poly-[3,4-ethylendioxy-2,5-thiophen]) |
| Matrix + Emitter | 80 nm, 5 Gew.-% Emitterkonzentration (aus Toluol oder Chlorbenzol aufgeschleudert), |
| Ba / Ag | 10 nm Ba / 150 nm Ag als Kathode. |

Strukturierte ITO-Substrate und das Material für die sogenannte Pufferschicht (PEDOT, eigentlich PEDOT: PSS) sind käuflich erhältlich (ITO von Technoprint und anderen, PEDOT:PPS als wässrige Dispersion Clevios Baytron P von H.C. Starck). Die Emissionsschicht wird in einer Inertgasatmosphäre, im vorliegenden Fall Argon, aufgeschleudert und 10 min bei 120˚C ausgeheizt. Zuletzt wird eine Kathode aus Barium und Aluminium im Vakuum aufgedampft. Die lösungsprozessierten Devices werden standardmäßig charakterisiert, die genannten OLED-Beispiele wurden nicht optimiert.

In Tabelle sind die Effizienz und die Spannung bei 500 cd / $m^2$ sowie die Farbe aufgeführt.

| Bsp. | Matrix Emitter | Effizienz [cd/A] | Spannung M | Farbe CIE x / y |
|---|---|---|---|---|
| 12 | PVK*<br>Beispiel 1 | 1,4 | 6,1 | 0,70 / 0,28 |
| 13 | Verbindung 1<br>Beispiel 1 | 2,6 | 5,7 | 0,69 / 0,31 |
| 14 | Verbindung 2<br>Beispiel 6 | 4,0 | 5,4 | 0,68 / 0,32 |
| 15 | Verbindung 2<br>Beispiel 8 | 3,7 | 5,5 | 0,69/0,31 |
| 16 | Verb. 2 (30 Gew.-%)<br>Verb. 3 (65 Gew.-%)<br>Beispiel 4 | 4,9 | 5,1 | 0,66/0,33 |
| **PVK: Mw = 1,100,000 g / mol bezogen von Aldrich | | | | |

**Patentansprüche**

**1.** Elektronische Vorrichtung, enthaltend mindestens einen Metallkomplex gemäß Formel (1),

$(L)_y\ M\text{-}[C{\equiv}N\text{-}R]_x$ Formel (1)

wobei für die verwendeten Symbole und Indizes gilt:

M ist ein penta- oder hexakoordiniertes Übergangsmetall;
L ist bei jedem Auftreten gleich oder verschieden ein mono-, bi-, oder tridentater Ligand, der an das Metall M bindet und der durch einen oder mehrere Reste $R^1$ substituiert sein kann; dabei kann der Ligand L auch an den Rest R der Isonitrilgruppe gebunden sein;
R ist bei jedem Auftreten gleich oder verschieden ein organischer Substituent mit 1 bis 60 C-Atomen, der durch einen oder mehrere Substituenten $R^1$ substituiert sein kann; dabei können mehrere Reste R auch miteinander verknüpft sein und dadurch einen mehrzähnigen Liganden bilden; außerdem kann der Rest R auch mit dem Liganden L verknüpft sein;
$R^1$ ist bei jedem Auftreten gleich oder verschieden H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere bevorzugt nicht benachbarte $CH_2$-Gruppen durch $R^2C{=}CR^2$, C≡C, $Si(R^2)_2$, $Ge(R^2)_2$, $Sn(R^2)_2$, C=O, C=S, C=Se, $C{=}NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination dieser Systeme; dabei können zwei oder mehrere Substituenten $R^1$ auch miteinander ein mono- oder polycyclisches aliphatisches, aromatisches und/oder benzoannelliertes Ringsystem bilden;
$R^2$ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch D oder F ersetzt sein können; dabei können zwei oder mehrere Substituenten $R^2$ auch miteinander ein mono- oder polycyclisches, aliphatisches oder aromatisches Ringsystem bilden;
x ist 3, 4, 5 oder 6;
y ist 0, 1, 2 oder 3 mit der Maßgabe, dass eine Koordinationszahl am Metall von 5 oder 6 erreicht wird.

2. Elektronische Vorrichtung nach Anspruch 1, enthaltend Anode, Kathode und mindestens eine Schicht, wobei diese Schicht mindestens eine organische bzw. metallorganische Verbindung enthält, wobei die organische elektronische Vorrichtung ausgewählt ist aus der Gruppe bestehend aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), insbesondere organische Elektrolumineszenzvorrichtungen.

3. Elektronische Vorrichtung nach Anspruch 1 oder 2, **dadurch gekennzeichnet, dass** die Verbindungen gemäß Formel (1) nicht geladen, d. h. elektrisch neutral, sind.

4. Elektronische Vorrichtung nach einem oder mehreren der Ansprüche 1 bis 3, **dadurch gekennzeichnet, dass** in Verbindungen gemäß Formel (1) M für ein pentakoordiniertes oder für ein hexakoordiniertes Übergangsmetall steht, ausgewählt aus der Gruppe bestehend aus Chrom, Molybdän, Wolfram, Rhenium, Ruthenium, Osmium, Rhodium, Iridium, Nickel, Platin, Kupfer, Silber und Gold, insbesondere Molybdän, Wolfram, Rhenium, Ruthenium, Osmium, Iridium, Platin und Gold.

5. Elektronische Vorrichtung nach einem oder mehreren der Ansprüche 1 bis 4, **dadurch gekennzeichnet, dass** ein oder mehrere der Isonitrilliganden monodentate Liganden sind, wobei der Substituent R gleich oder verschieden bei jedem Auftreten für eine geradkettige Alkylgruppe mit 1 bis 40 C-Atomen oder eine geradkettige Alkenyl- oder Alkinylgruppe mit 2 bis 40 C-Atomen oder eine verzweigte oder cyclische Alkyl, Alkenyl- oder Alkinylgruppe mit 3 bis 40 C-Atomen, die jeweils mit einem oder mehreren Resten $R^1$ substituiert sein kann, wobei eine oder mehrere

bevorzugt nicht benachbarte $CH_2$-Gruppen durch $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, oder für ein monovalentes aromatisches oder heteroaromatisches Ringsystem mit 5 bis 60 aromatischen Ringatomen, das jeweils durch einen oder mehrere Reste $R^1$ substituiert sein kann, oder für eine Kombination dieser Systeme steht.

**6.** Elektronische Vorrichtung nach einem oder mehreren der Ansprüche 1 bis 5, **dadurch gekennzeichnet, dass** die Substituenten R miteinander und/oder zusammen mit dem Liganden L eine kettenförmige, verzweigte oder mono- oder polycyclische, aliphatische, aromatische und/oder benzoannellierte Struktur bilden und die Liganden damit mehrzähnigen bzw. polypodalen Ligandencharakter aufweisen.

**7.** Elektronische Vorrichtung nach einem oder mehreren der Ansprüche 1 bis 6, **dadurch gekennzeichnet, dass** der Metallkomplex einen oder mehrere Isonitrilliganden mit einer Struktur gemäß Formel (2) oder Formel (3) enthält,

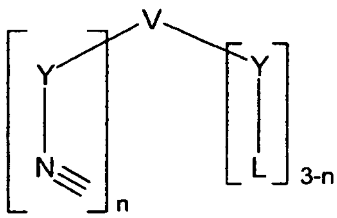

Formel (2)

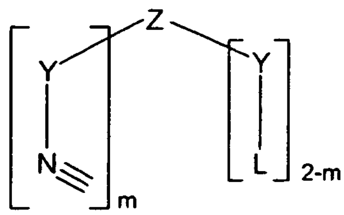

Formel (3)

wobei $R^1$ und L die in Anspruch 1 genannten Bedeutungen haben und für die weiteren verwendeten Symbole und Indizes gilt:

Y ist bei jedem Auftreten gleich oder verschieden eine Einfachbindung, O, S, $N(R^1)$, C=O, eine geradkettige Alkylengruppe mit 1 bis 6 C-Atomen oder eine verzweigte oder cyclische Alkylengruppe mit 3 bis 6 C-Atomen, die jeweils mit einem oder mehreren Resten $R^1$ substituiert sein kann, wobei eine oder mehrere nicht benachbarte $CH_2$-Gruppen durch $R^1C=CR^1$, $NR^1$, $Si(R^1)_2$, O oder S ersetzt sein können und wobei ein oder mehrere H-Atome durch D, F, Cl, Br, I, CN oder $NO_2$ ersetzt sein können, oder eine Arylen- oder Heteroarylengruppe mit 5 bis 20 aromatischen Ringatomen, welche mit einem oder mehreren Resten $R^1$ substituiert sein kann, oder eine Kombination dieser Systeme;

V ist B, $B(R^1)^-$, $CR^1$, CO-, $CN(R^1)_2$, $SiR^1$, N, NO, $N(R^1)^+$, P, $P(R^1)^+$, PO, PS, As, $As(R^1)^+$, AsO, $S^+$, $Se^+$, oder eine Einheit gemäß Formel (4), (5), (6) oder (7),

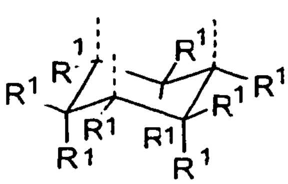

Formel (4)

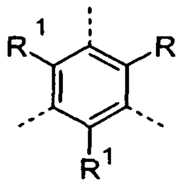

Formel (5)

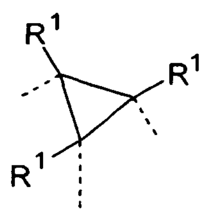

Formel (6)

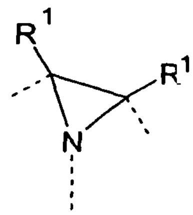

Formel (7)

wobei die gestrichelten Bindungen jeweils die Bindung an Y andeuten;

Z ist $BR^1$, $B(R^1)_2^-$, $C(R^1)_2$, C(=O), $Si(R^1)_2$, $NR^1$, $PR^1$, $P(R^1)_2^+$, $PO(R^1)$, $PS(R^1)$, $AsR^1$, $AsO(R^1)$, AsS, O, S, Se, oder eine Einheit gemäß Formel (8) bis (17),

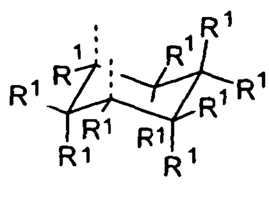

Formel (8)

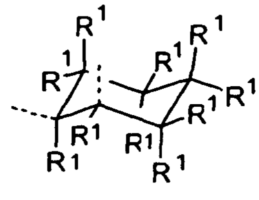

Formel (9)

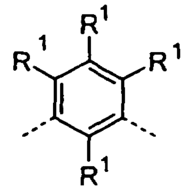

Formel (10)

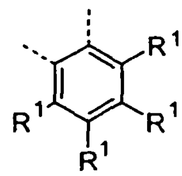

Formel (11)

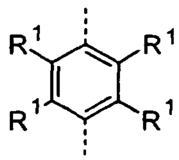

Formel (12)

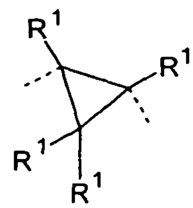

Formel (13)

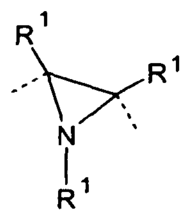

Formel (14)

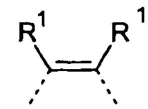

Formel (15)

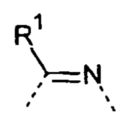

Formel (16)

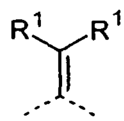

Formel (17)

wobei die gestrichelten Bindungen jeweils die Bindung an Y andeuten;

n ist 1, 2 oder 3, bevorzugt 2 oder 3;
m ist 1 oder 2, bevorzugt 2.

**8.** Elektronische Vorrichtung nach Anspruch 7, **dadurch gekennzeichnet, dass** die Anzahl der Atome in den beiden Gruppen Y und in der Gruppe V bzw. Z, die die direkte Verbindung zwischen den Isonitrilgruppen bzw. zwischen der Isonitrilgruppe und der Ligandengruppe L darstellt, zwischen 6 und 12 Atomen, bevorzugt zwischen 7 und 10 Atomen, besonders bevorzugt zwischen 7 und 9 Atomen beträgt.

**9.** Elektronische Vorrichtung nach Anspruch 7 oder 8, **dadurch gekennzeichnet, dass** die Liganden ausgewählt sind aus Liganden der Formeln (18) bis (28), welche jeweils durch einen oder mehrere Reste $R^1$ substituiert sein können:

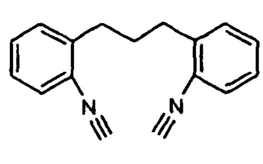

Formel (18)

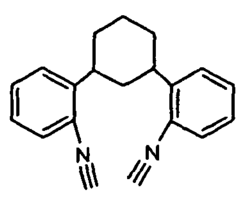

Formel (19)

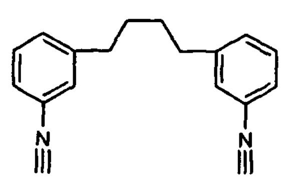

Formel (20)

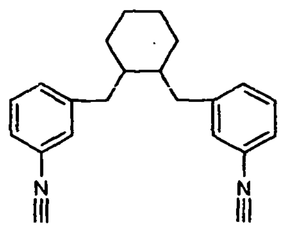

Formel (21)

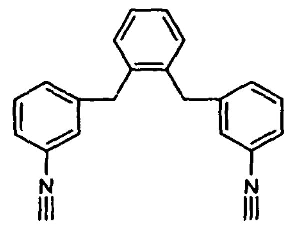

Formel (22)

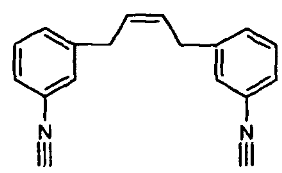

Formel (23)

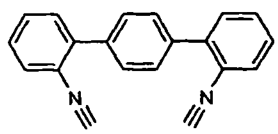

Formel (24)

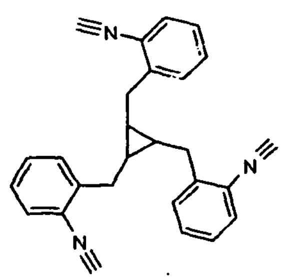

Formel (25)

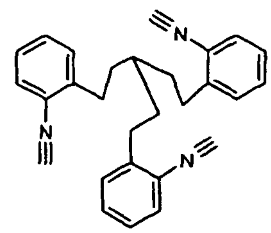

Formel (26)

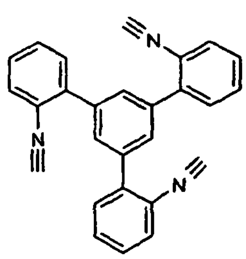

Formel (27)

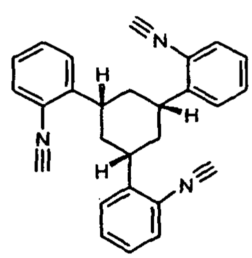

Formel (28)

**10.** Elektronische Vorrichtung nach einem oder mehreren der Ansprüche 1 bis 9, **dadurch gekennzeichnet, dass** die Liganden L ausgewählt sind aus Kohlenmonoxid, Stickstoffmonoxid, Aminen, Phosphinen, Phosphiten, Arsinen, Stibinen, stickstoffhaltigen Heterocyclen, Carbenen, Hydrid, Deuterid, den Halogeniden F, Cl, Br und I, Alkylacetyliden, Arylacetyliden, Cyanid, Azid, Cyanat, Isocyanat, Thiocyanat, Isothiocyanat, aliphatischen oder aromatischen Alkoholaten, aliphatischen oder aromatischen Thioalkoholaten, Amiden, Carboxylaten, Arylgruppen, anionischen, stickstoffhaltigen Heterocyclen, $O^{2-}$, $S^{2-}$, Carbide, welche zu einer Koordination der Form R-C≡M führen, und Nitrene, welche zu einer Koordination der Form R-N=M führen, wobei R allgemein für einen Substituenten steht, oder $N^{3-}$, Diaminen, Iminen, Diminen, Heterocyclen enthaltend zwei Stickstoffatome, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten abgeleitet von Dialkoholen, Dithiolaten abgeleitet von Dithiolen, Borate stickstoffhaltiger Heterocyclen, $\eta^5$-Cyclopentadienyl, $\eta^5$-Pentamethylcyclopentadienyl, $\eta^6$-Benzol oder $\eta^7$-Cycloheptatrienyl, welche jeweils durch einen oder mehrere Reste $R^1$ substituiert sein können, oder dass der Ligand L ein bidentater monoanionischer Ligand ist, welcher mit dem Metall einen cyclometallierten Fünfring oder Sechsring mit mindestens einer Metall-Kohlenstoff-Bindung aufweist, insbesondere eine Kombination aus zwei Gruppen, wie sie durch die Formeln (29) bis (56) dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet, wobei der Ligand L dann aus den Gruppen der Formeln (29) bis (56) gebildet wird, indem diese Gruppen jeweils an der durch # gekennzeichneten Position aneinander binden, und die Position, an der die Gruppen an das Metall koordinieren, durch * gekennzeichnet ist:

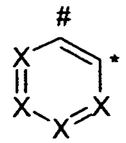

Formel (29)

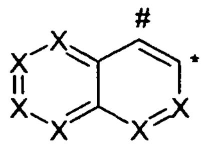

Formel (30)

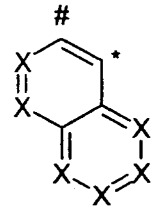

Formel (31)

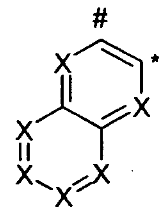

Formel (32)

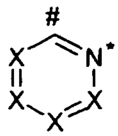

Formel (33)

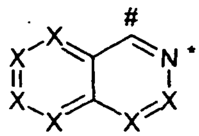

Formel (34)

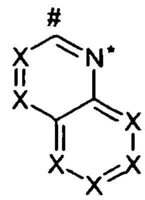

Formel (35)

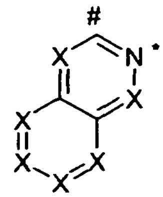

Formel (36)

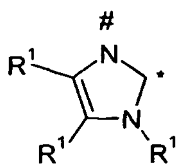

Formel (37)

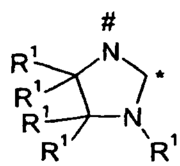

Formel (38)

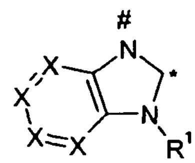

Formel (39)

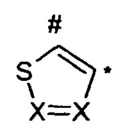

Formel (40)

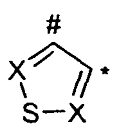

Formel (41)

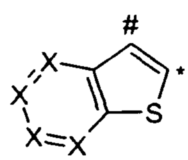

Formel (42)

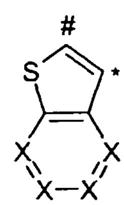

Formel (43)

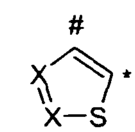

Formel (44)

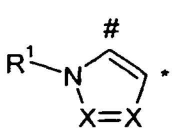

Formel (45)

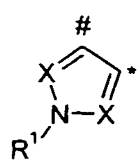

Formel (46)

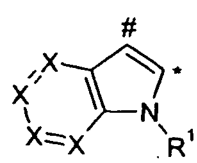

Formel (47)

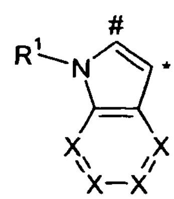

Formel (48)

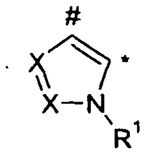

Formel (49)

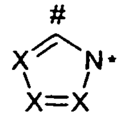

Formel (50)

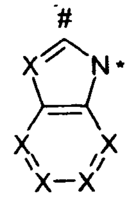

Formel (51)

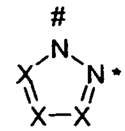

Formel (52)

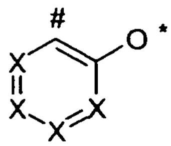

Formel (53)

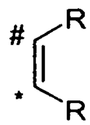

Formel (54)

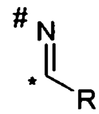

Formel (55)

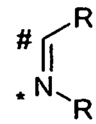

Formel (56)

dabei haben die verwendeten Symbole dieselbe Bedeutung, wie in Anspruch 1 beschrieben, und X steht gleich oder verschieden bei jedem Auftreten für $CR^1$ oder N mit der Maßgabe, dass maximal drei Symbole X in jeder Gruppe für N stehen;
oder dass der Ligand L ein 1,3,5-cis-Cyclohexanderivat, insbesondere der Formel (57), ein 1,1,1-Tri(methylen) methanderivat, insbesondere der Formel (58) und ein 1,1,1-trisubstituiertes Methan, insbesondere der Formel (59) und (60) ist,

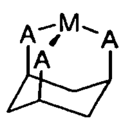

Formel (57)

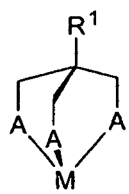

Formel (58)

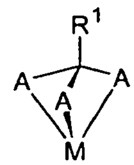

Formel (59)

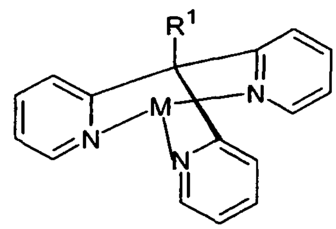

Formel (60)

wobei in den Formeln jeweils die Koordination an das Metall M dargestellt ist, $R^1$ die in Anspruch 1 genannte Bedeutung hat und A, gleich oder verschieden bei jedem Auftreten, für $O^-$, $S^-$, $COO^-$, $P(R^1)_2$ oder $N(R^1)_2$ steht.

**11.** Organische Elektrolumineszenzvorrichtung nach einem oder mehreren der Ansprüche 1 bis 10, enthaltend Kathode, Anode und eine oder mehrere emittierende Schichten und außerdem optional jeweils eine oder mehrere Lochinjektionsschichten, Lochtransportschichten, Lochblockierschichten, Elektronentransportschichten, Elektroneninjektionsschichten, Exzitonenblockierschichten, Ladungserzeugungsschichten und/oder organische oder anorganische p/n-Übergänge, **dadurch gekennzeichnet, dass** die Verbindung gemäß Formel (1) als Emissionsmaterial in einer emittierenden Schicht eingesetzt wird.

**12.** Organische Elektrolumineszenzvorrichtung nach einem oder mehreren der Ansprüche 1 bis 11, **dadurch gekennzeichnet, dass** die Verbindung gemäß Formel (1) in einer emittierenden Schicht in Kombination mit einem oder mehreren Matrixmaterialien eingesetzt wird, insbesondere ausgewählt aus CBP (N,N-Biscarbazolylbiphenyl), Carbazolderivaten, Azacarbazolen, Ketonen, Phosphinoxiden, Sulfoxiden, Sulfonen, Oligophenylenen, aromatischen Aminen, bipolaren Matrixmaterialien, Silanen, 9,9-Diarylfluorenderivaten, Azaborolen oder Boronestern.

**13.** Verfahren zur Herstellung einer elektronischen Vorrichtung nach einem oder mehreren der Ansprüche 1 bis 12,

**dadurch gekennzeichnet, dass** eine oder mehrere Schichten mit einem Sublimationsverfahren beschichtet werden und/oder dass eine oder mehrere Schichten mit dem OVPD (Organic Vapour Phase Deposition) Verfahren oder mit Hilfe einer Trägergassublimation beschichtet werden oder mit dem OVJP (Organic Vapour Jet Printing) Verfahren beschichtet werden und/oder dass eine oder mehrere Schichten aus Lösung oder mit einem Druckverfahren hergestellt werden.

**14.** Verbindung der Formel (1'),

$(L)_y\ M\text{-}[C{\equiv}N\text{-}R]_x$ Formel (1')

wobei die verwendeten Symbole und Indizes die in Anspruch 1 genannten Bedeutungen haben und mindestens einer der Isonitrilliganden ausgewählt ist aus Liganden der Formel (27) oder (28), welcher jeweils auch durch einen oder mehrere Reste $R^1$ substituiert sein kann:

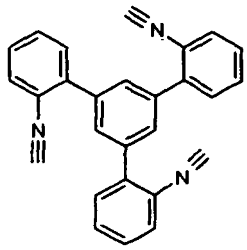

Formel (27)

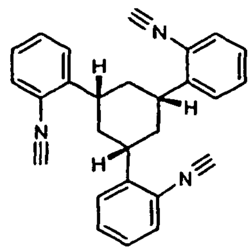

Formel (28)

**15.** Verbindung der Formel (27) und (28), welche jeweils durch einen oder mehrere Reste $R^1$ substituiert sein können, wobei $R^1$ die in Anspruch 1 genannte Bedeutung hat:

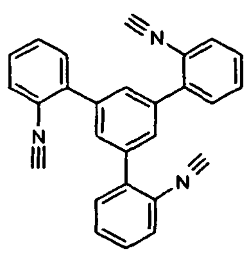

Formel (27)

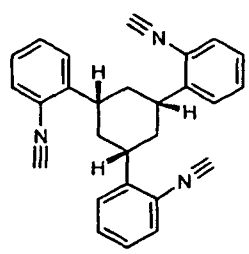

Formel (28)

**16.** Lösung oder Formulierung enthaltend mindestens eine Verbindung gemäß Formel (1') sowie mindestens ein organisches Lösungsmittel, bevorzugt ausgewählt aus der Klasse der aromatischen organischen Lösungsmittel.

## Claims

**1.** Electronic device comprising at least one metal complex of the formula (1),

$(L)_y\ M\text{-}[C{\equiv}N\text{-}R]_x$ formula (1)

where the following applies to the symbols and indices used:

M is a penta- or hexacoordinated transition metal;
L is on each occurrence, identically or differently, a mono-, bi- or tridentate ligand which bonds to the metal M and may be substituted by one or more radicals $R^1$; the ligand L here may also be bonded to the radical R of the isonitrile group;

R is on each occurrence, identically or differently, an organic substituent having 1 to 60 C atoms, which may be substituted by one or more substituents $R^1$; a plurality of radicals R here may also be linked to one another and thus form a polydentate ligand; in addition, the radical R may also be linked to the ligand L;

$R^1$ is on each occurrence, identically or differently, H, D, F, Cl, Br, I, $N(R^2)_2$, CN, $NO_2$, $Si(R^2)_3$, $B(OR^2)_2$, C(=O) $R^2$ $P(=O)(R^2)_2$, $S(=O)R^2$, $S(=O)_2R^2$, $OSO_2R^2$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals $R^2$, where one or more, preferably non-adjacent $CH_2$ groups may be replaced by $R^2C=CR^2$, C=C, $Si(R^2)_2$, $Ge(R^2)_2$, $Sn(R^2)_2$, C=O, C=S, C=Se, $C=NR^2$, $P(=O)(R^2)$,SO, $SO_2$, $NR^2$, O, S or $CONR^2$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^2$ or an aryloxy or heteroaryloxy group having 5 to 60 aromatic ring atoms, which may be substituted by one or more radicals $R^2$, or a diarylamino group, diheteroarylamino group or aryl-heteroarylamino group having 10 to 40 aromatic ring atoms, which may be substituted by one or more radicals $R^2$, or a combination of these systems; two or more substituents $R^1$ here may also form a mono- or polycyclic aliphatic, aromatic and/or benzo-fused ring system with one another;

$R^2$ is on each occurrence, identically or differently, H, D, F or an aliphatic, aromatic and/or heteroaromatic hydrocarbon radical having 1 to 20 C atoms, in which, in addition, one or more H atoms may be replaced by D or F; two or more substituents $R^2$ here may also form a mono- or polycyclic, aliphatic or aromatic ring system with one another;

x is 3, 4, 5 or 6;

y is 0, 1, 2 or 3, with the proviso that a coordination number on the metal of 5 or 6 is achieved.

**2.** Electronic device according to Claim 1, comprising anode, cathode and at least one layer, where this layer comprises at least one organic or organometallic compound, where the organic electronic device is selected from the group consisting of organic electroluminescent devices (= organic light-emitting diodes, OLEDs, PLEDs), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), light-emitting electrochemical cells (LECs) and organic laser diodes (O-lasers), in particular organic electroluminescent devices.

**3.** Electronic device according to Claim 1 or 2, **characterised in that** the compounds of the formula (1) are uncharged, i.e. are electrically neutral.

**4.** Electronic device according to one or more of Claims 1 to 3, **characterised in that** M in compounds of the formula (1) stands for a penta-coordinated or hexacoordinated transition metal selected from the group consisting of chromium, molybdenum, tungsten, rhenium, ruthenium, osmium, rhodium, iridium, nickel, platinum, copper, silver and gold, in particular molybdenum, tungsten, rhenium, ruthenium, osmium, iridium, platinum and gold.

**5.** Electronic device according to one or more of Claims 1 to 4, **characterised in that** one or more of the isonitrile ligands are monodentate ligands, where the substituent R stands, identically or differently on each occurrence, for a straight-chain alkyl group having 1 to 40 C atoms or a straight-chain alkenyl or alkynyl group having 2 to 40 C atoms or a branched or cyclic alkyl, alkenyl or alkynyl group having 3 to 40 C atoms, each of which may be substituted by one or more radicals $R^1$, where one or more, preferably non-adjacent $CH_2$ groups may be replaced by $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, or for a monovalent aromatic or heteroaromatic ring system having 5 to 60 aromatic ring atoms, which may in each case be substituted by one or more radicals $R^1$, or for a combination of these systems.

**6.** Electronic device according to one or more of Claims 1 to 5, **characterised in that** the substituents R form a chain-shaped, branched or mono- or polycyclic, aliphatic, aromatic and/or benzo-fused structure with one another and/or together with the ligand L, and the ligands thus have a polydentate or polypodal ligand character.

**7.** Electronic device according to one or more of Claims 1 to 6, **characterised in that** the metal complex contains one or more isonitrile ligands having a structure of the formula (2) or formula (3),

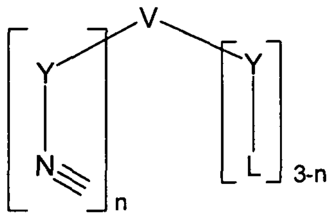

formula (2)

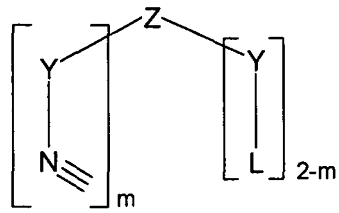

formula (3)

where $R^1$ and L have the meanings mentioned in Claim 1, and the following applies to the other symbols and indices used:

Y is on each occurrence, identically or differently, a single bond, O, S, $N(R^1)$, C=O, a straight-chain alkylene group having 1 to 6 C atoms or a branched or cyclic alkylene group having 3 to 6 C atoms, each of which may be substituted by one or more radicals $R^1$, where one or more non-adjacent $CH_2$ groups may be replaced by $R^1C{=}CR^1$, $NR^1$, $Si(R^1)_2$, O or S and where one or more H atoms may be replaced by D, F, Cl, Br, I, CN or $NO_2$, or an arylene or heteroarylene group having 5 to 20 aromatic ring atoms, which may be substituted by one or more radicals $R^1$, or a combination of these systems;

V is B, $B(R^1)^-$, $CR^1$, $CO^-$, $CN(R^1)_2$, $SiR^1$, N, NO, $N(R^1)^+$, P, $P(R^1)^+$, PO, PS, As, $As(R^1)^+$, AsO, $S^+$, $Se^+$, or a unit of the formula (4), (5), (6) or (7),

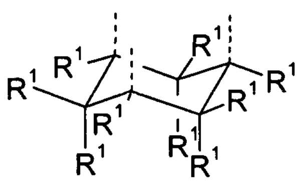

formula (4)

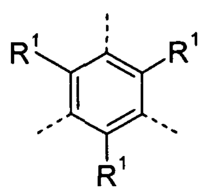

formula (5)

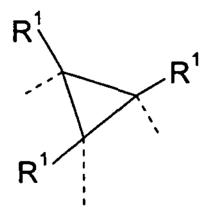

formula (6)

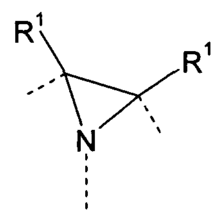

formula (7)

where the dashed bonds in each case indicate the bonding to Y;

Z is $BR^1$, $B(R^1)_2^-$, $C(R^1)_2$, C(=O), $Si(R^1)_2$, $NR^1$, $PR^1$, $P(R^1)_2^+$, $PO(R^1)$, $PS(R^1)$, $AsR^1$, $AsO(R^1)$ AsS, O, S, Se, or a unit of the formulae (8) to (17),

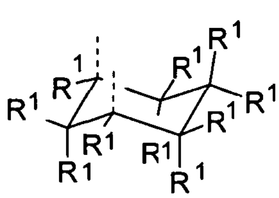

formula (8)

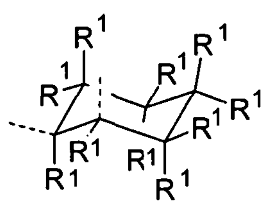

formula (9)

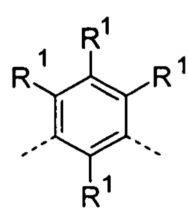

formula (10)

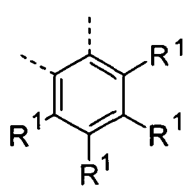

formula (11)

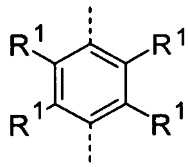
formula (12)

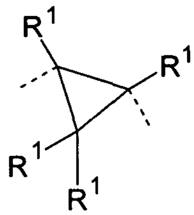
formula (13)

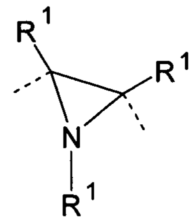
formula (14)

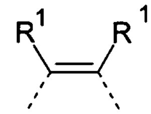
formula (15)

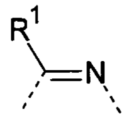
formula (16)

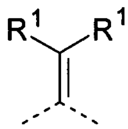
formula (17)

where the dashed bonds in each case indicate the bonding to Y;

n is 1, 2 or 3, preferably 2 or 3;
m is 1 or 2, preferably 2.

**8.** Electronic device according to Claim 7, **characterised in that** the number of atoms in the two groups Y and in the group V or Z which represent the direct connection between the isonitrile groups or between the isonitrile group and the ligand group L is between 6 and 12 atoms, preferably between 7 and 10 atoms, particularly preferably between 7 and 9 atoms.

**9.** Electronic device according to Claim 7 or 8, **characterised in that** the ligands are selected from ligands of the formulae (18) to (28), each of which may be substituted by one or more radicals $R^1$:

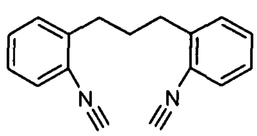
formula (18)

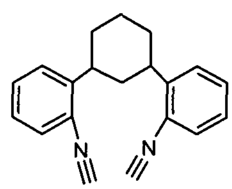
formula (19)

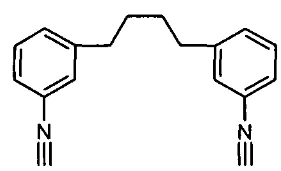
formula (20)

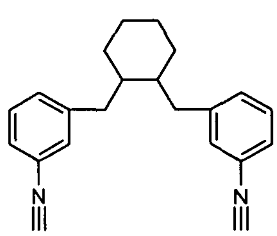
formula (21)

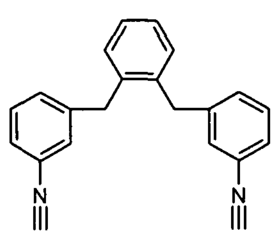
formula (22)

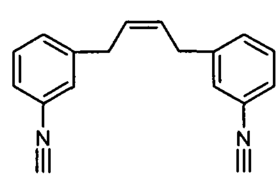
formula (23)

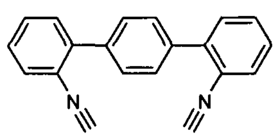

formula (24)

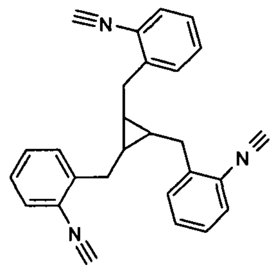

formula (25)

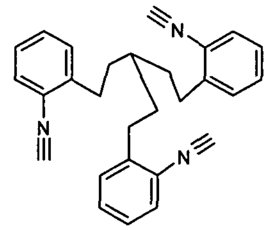

formula (26)

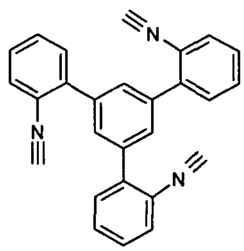

formula (27)

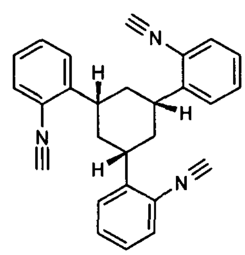

formula (28)

**10.** Electronic device according to one or more of Claims 1 to 9, **characterised in that** the ligands L are selected from carbon monoxide, nitrogen monoxide, amines, phosphines, phosphites, arsines, stibines, nitrogen-containing heterocycles, carbenes, hydride, deuteride, the halides F, Cl, Br and I, alkylacetylides, arylacetylides, cyanide, azide, cyanate, isocyanate, thiocyanate, isothiocyanate, aliphatic or aromatic alcoholates, aliphatic or aromatic thioalcoholates, amides, carboxylates, aryl groups, anionic, nitrogen-containing heterocycles, $O^{2-}$, $S^{2-}$, carbides, which result in coordination in the form R-C≡M, and nitrenes, which result in coordination in the form R-N=M, where R generally stands for a substituent, or $N^{3-}$, diamines, imines, diimines, heterocycles containing two nitrogen atoms, diphosphines, 1,3-diketonates derived from 1,3-diketones, 3-ketonates derived from 3-ketoesters, carboxylates derived from aminocarboxylic acids, salicyliminates derived from salicylimines, dialcoholates derived from dialcohols, dithiolates derived from dithiols, borates of nitrogen-containing heterocycles, $\eta^5$-cyclopentadienyl, $\eta^5$-pentamethylcyclopentadienyl, $\eta^6$-benzene or $\eta^7$-cycloheptatrienyl, each of which may be substituted by one or more radicals $R^1$, or **in that** the ligand L is a bidentate monoanionic ligand which, with the metal, forms a cyclometallated five- or six-membered ring with at least one metal-carbon bond, in particular a combination of two groups, as represented by the formulae (29) to (56), where one group is bonded via a neutral nitrogen atom or a carbene atom and the other group is bonded via a negatively charged carbon atom or a negatively charged nitrogen atom, where the ligand L is then formed from the groups of the formulae (29) to (56) through these groups bonding to one another in each case at the position denoted by #, and the position at which the groups coordinate to the metal is denoted by *:

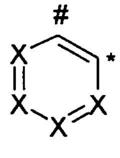

formula (29)

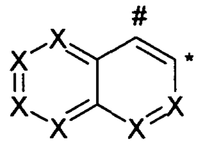

formula (30)

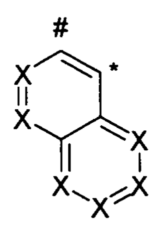

formula (31)

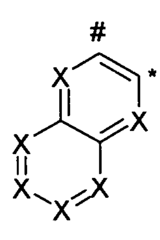

formula (32)

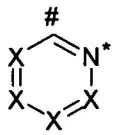

formula (33)

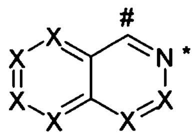

formula (34)

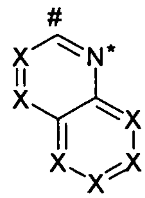

formula (35)

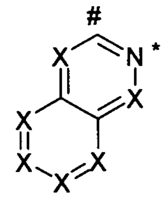

formula (36)

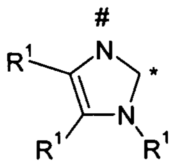

formula (37)

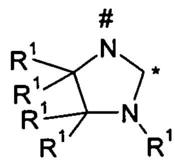

formula (38)

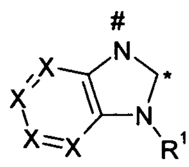

formula (39)

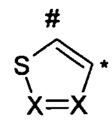

formula (40)

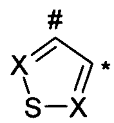

formula (41)

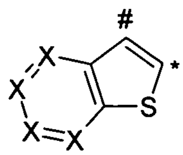

formula (42)

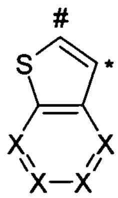

formula (43)

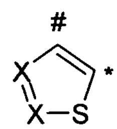

formula (44)

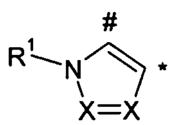

formula (45)

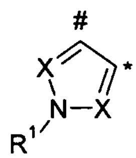

formula (46)

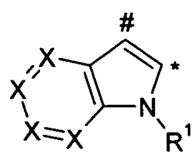

formula (47)

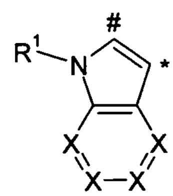

formula (48)

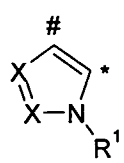

formula (49)

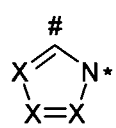

formula (50)

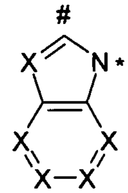

formula (51)

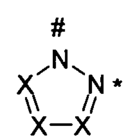

formula (52)

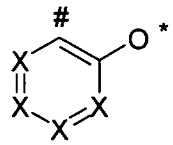
formula (53)

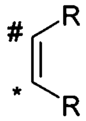
formula (54)

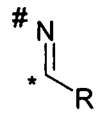
formula (55)

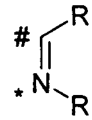
formula (56)

the symbols used here have the same meaning as described in Claim 1, and X stands, identically or differently on each occurrence, for $CR^1$ or N, with the proviso that a maximum of three symbols X in each group stand for N;
or **in that** the ligand L is a 1,3,5-cis-cyclohexane derivative, in particular of the formula (57), a 1,1,1-tri(methylene) methane derivative, in particular of the formula (58), or a 1,1,1-trisubstituted methane, in particular of the formulae (59) and (60),

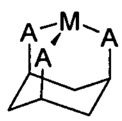
formula (57)

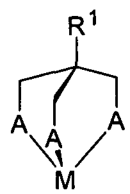
formula (58)

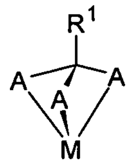
formula (59)

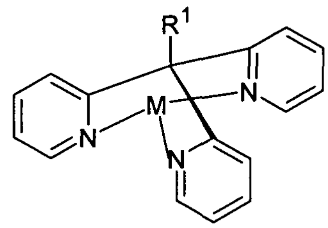
formula (60)

where the coordination to the metal M is shown in each of the formulae, $R^1$ has the meaning mentioned in Claim 1, and A stands, identically or differently on each occurrence, for $O^-$, $S^-$, $COO^-$, $P(R^1)_2$ or $N(R^1)_2$.

**11.** Organic electroluminescent device according to one or more of Claims 1 to 10, comprising cathode, anode and one or more emitting layers and in addition optionally in each case one or more hole-injection layers, hole-transport layers, hole-blocking layers, electron-transport layers, electron-injection layers, exciton-blocking layers, charge-generation layers and/or organic or inorganic p/n junctions, **characterised in that** the compound of the formula (1) is employed as emission material in an emitting layer.

**12.** Organic electroluminescent device according to one or more of Claims 1 to 11, **characterised in that** the compound of the formula (1) is employed in an emitting layer in combination with one or more matrix materials, in particular selected from CBP (N,N-biscarbazolyl-biphenyl), carbazole derivatives, azacarbazoles, ketones, phosphine oxides, sulfoxides, sulfones, oligophenylenes, aromatic amines, bipolar matrix materials, silanes, 9,9-diarylfluorene derivatives, azaboroles and boronic esters.

**13.** Process for the production of an electronic device according to one or more of Claims 1 to 12, **characterised in that** one or more layers are applied by means of a sublimation process and/or **in that** one or more layers are applied by means of the OVPD (organic vapour phase deposition) process or with the aid of carrier-gas sublimation or by means of the OVJP (organic vapour jet printing) process and/or **in that** one or more layers are produced from solution or by means of a printing process.

**14.** Compound of the formula (1'),

$$(L)_y\ M\text{-}[C{\equiv}N\text{-}R]_x \qquad \text{formula (1')}$$

where the symbols and indices used have the meanings mentioned in Claim 1, and at least one of the isonitrile ligands is selected from ligands of the formula (27) or (28), each of which may also be substituted by one or more radicals $R^1$:

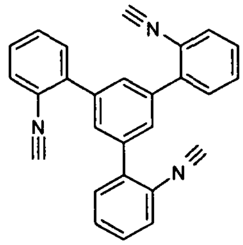
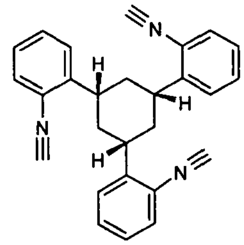

formula (27) formula (28) .

**15.** Compound of the formula (27) or (28), each of which may be substituted by one or more radicals $R^1$, where $R^1$ has the meaning mentioned in Claim 1:

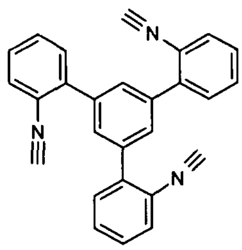
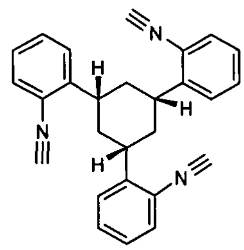

formula (27) formula (28) .

**16.** Solution or formulation comprising at least one compound of the formula (1') and at least one organic solvent, preferably selected from the class of the aromatic organic solvents.

## Revendications

**1.** Dispositif électronique comprenant au moins un complexe métallique de la formule (1),

$(L)_y\ M\text{-}[C{\equiv}N\text{-}R]_x$ formule (1)

où ce qui suit s'applique aux symboles et indices utilisés :

M est un métal de transition penta- ou hexacoordonné ;
L est, pour chaque occurrence, de manière identique ou différente, un ligand mono-, bi- ou tridenté qui se lie sur le métal M et peut être substitué par un ou plusieurs radicaux $R^1$ ; le ligand L ici peut également être lié au radical R du groupe isonitrile ;
R est, pour chaque occurrence, de manière identique ou différente, un substituant organique comportant de 1 à 60 atomes de C, lesquels peuvent être substitués par un ou plusieurs substituants $R^1$ ; une pluralité de radicaux R ici peuvent également être liés les uns aux autres et ainsi former un ligand polydenté ; en outre, le radical R peut également être lié au ligand L ;
$R^1$ est, pour chaque occurrence, de manière identique ou différente, H, D, F, Cl, Br, I, $N(R^2)_2$, CN, $NO_2$, Si $(R^2)_3$, $B(OR^2)_2$, $C(=O)R^2$, $P(=O)(R^2)_2$, $S(=O)R^2$ $S(=O)_2R^2$, $OSO_2R^2$, un groupe alkyle, alcoxy ou thioalcoxy en chaîne droite comportant de 1 à 40 atomes de C ou un groupe alkényle ou alkynyle en chaîne droite comportant de 2 à 40 atomes de C ou un groupe alkyle, alkényle, alkynyle, alcoxy ou thioalcoxy ramifié ou cyclique comportant de 3 à 40 atomes de C, dont chacun peut être substitué par un ou plusieurs radicaux $R^2$, où un ou plusieurs groupes $CH_2$, de préférence non adjacents, peuvent être rem- placés par $R^2C{=}CR^2$, $C{\equiv}C$, $Si(R^2)_2$, $Ge(R^2)_2$, $Sn(R^2)_2$, C=O, C=S, C=Se, $C{=}NR^2$, $P(=O)(R^2)$, SO, $SO_2$, $NR^2$, O, S ou $CONR^2$ et où un ou plusieurs atomes de H peuvent être remplacés par D, F, Cl, Br, I, CN ou $NO_2$, ou un système de cycle aromatique ou hétéroaromatique comportant de 5 à 60 atomes de cycle aromatique, lesquels peuvent dans chaque cas être substitués par un ou plusieurs radicaux $R^2$, ou un groupe aryloxy ou hétéroaryloxy comportant de 5 à 60 atomes de cycle aromatique, lesquels peuvent être substitués par un ou plusieurs radicaux $R^2$, ou un groupe diarylamino,

un groupe dihétéroarylamino ou un groupe arylhétéroarylamino comportant 10 à 40 atomes de cycle aromatique, lesquels peuvent être substitués par un ou plusieurs radicaux $R^2$ ou une combinaison de ces systèmes ; deux substituants $R^1$ ou plus peuvent également ici former un système de cycle aliphatique, aromatique et/ou benzo-fusionné l'un avec l'autre;

$R^2$ est, pour chaque occurrence, de manière identique ou différente, H, D, F ou un radical hydrocarbone aliphatique, aromatique et/ou hétéroaromatique comportant de 1 à 20 atomes de C, où, en outre, un ou plusieurs atomes de H peuvent être remplacés par D ou F ; deux substituants $R^2$ ou plus peuvent ici également former un système de cycle aliphatique ou aromatique monocyclique ou polycyclique l'un avec l'autre ;

x est 3, 4, 5 ou 6 ;

y est 0, 1, 2 ou 3, sour réserve qu'un numéro de coordination sur le métal de 5 ou 6 est réalisé.

2. Dispositif électronique selon la revendication 1, comprenant une anode, une cathode et au moins une couche, où cette couche comprend au moins un composé organique ou organométallique, où le dispositif électronique organique est choisi parmi le groupe constitué par des dispositifs électroluminescents organiques (= diodes émettrices de lumière organiques, OLED, PLED), des circuits intégrés organiques (O-IC), des transistors à effet de champ organiques (O-FET), des transistors à film mince organiques (O-TFT), des transistors émetteurs de lumière organiques (O-LET), des cellules solaires organiques (O-SC), des détecteurs optiques organiques, des photorécepteurs organiques, des dispositifs à extinction de champ organiques (O-FQD), des cellules électrochimiques émettrices de lumière (LEC) et des diodes laser organiques (O-laser), en particulier des dispositifs électroluminescents organiques.

3. Dispositif électronique selon la revendication 1 ou 2, **caractérisé en ce que** les composés de la formule (1) sont non chargés, i.e. sont électriquement neutres.

4. Dispositif électronique selon une ou plusieurs des revendications 1 à 3, **caractérisé en ce que** M dans les composés de la formule (1) représente un métal de transition pentacoordonné ou hexacoordonné choisi parmi le groupe constitué par chrome, molybdène, tungstène, rhénium, ruthénium, osmium, rhodium, iridium, nickel, platine, cuivre, argent et or, en particulier molybdène, tungstène, rhénium, ruthénium, osmium, iridium, platine et or.

5. Dispositif électronique selon une ou plusieurs des revendications 1 à 4, **caractérisé en ce qu'**un ou plusieurs des ligands isonitrile sont des ligands monodentés, où le substituant R représente, de manière identique ou différente pour chaque occurrence, un groupe alkyle en chaîne droite comportant de 1 à 40 atomes de C ou un groupe alkényle ou alkynyle en chaîne droite comportant de 2 à 40 atomes de C ou un groupe alkyle, alkényle ou alkynyle ramifié ou cyclique comportant de 3 à 40 atomes de C, dont chacun peut être substitué par un ou plusieurs radicaux $R^1$, où un ou plusieurs groupes $CH_2$ non adjacents, de préférence deux, peuvent être remplacés par $R^1C=CR^1$, C=C, $Si(R^1)_2$, $Ge(R^1)_2$, $Sn(R^1)_2$, C=O, C=S, C=Se, $C=NR^1$, $P(=O)(R^1)$, SO, $SO_2$, $NR^1$, O, S ou $CONR^1$ et où un ou plusieurs atomes de H peuvent être remplacés par D, F, Cl, Br, I, CN ou $NO_2$, ou un système de cycle aromatique ou hétéroaromatique monovalent comportant de 5 à 60 atomes de cycle aromatique, lesquels peuvent dans chaque cas être substitués par un ou plusieurs radicaux $R^1$, ou une combinaison de ces systèmes.

6. Dispositif électronique selon une ou plusieurs des revendications 1 à 5, **caractérisé en ce que** les substituants R forment une structure en forme de chaîne, ramifiée ou monocyclique ou polycyclique, aliphatique, aromatique et/ou benzo-fusionnée les uns avec les autres et/ou en association avec le ligand L, et les ligands présentent ainsi un caractère de ligand polydenté ou polypodal.

7. Dispositif électronique selon une ou plusieurs des revendications 1 à 6, **caractérisé en ce que** le complexe métallique contient un ou plusieurs ligands isonitrile présentant une structure de la formule (2) ou de la formule (3),

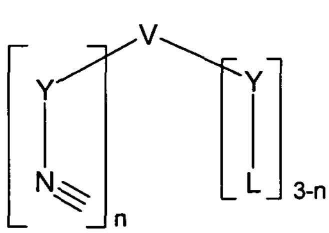

formule (2)

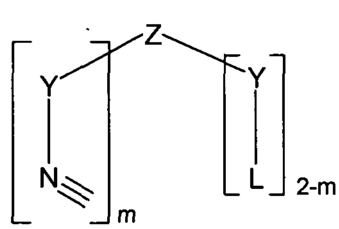

formule (3)

où $R^1$ et L présentent les significations mentionnées dans la revendication 1, et ce qui suit s'applique aux autres symboles et indices utilisés :

Y est, pour chaque occurrence, de manière identique ou différente, une liaison simple, O, S, $N(R^1)$, C=O, un groupe alkylène en chaîne droite comportant de 1 à 6 atomes de C ou un groupe alkylène ramifié ou cyclique comportant de 3 à 6 atomes de C, dont chacun peut être substitué par un ou plusieurs radicaux $R^1$, où un ou plusieurs groupes $CH_2$ non adjacents peuvent être remplacés par $R^1C=CR^1$, $NR^1$, $Si(R^1)_2$, O ou S et où un ou plusieurs atomes de H peuvent être remplacés par D, F, Cl, Br, I, CN ou $NO_2$, ou un groupe arylène ou hétéroarylène comportant de 5 à 20 atomes de cycle aromatique, lesquels peuvent être substitués par un ou plusieurs radicaux $R^1$, ou une combinaison de ces systèmes ;

V est B, $B(R^1)$, $CR^1$, $CO^-$, $CN(R^1)_2$, $SiR^1$, N, NO, $N(R^1)^+$, P, $P(R^1)^+$, PO, PS, As, $As(R^1)^+$, AsO, $S^+$, $Se^+$, ou une unité de la formule (4), (5), (6) ou (7),

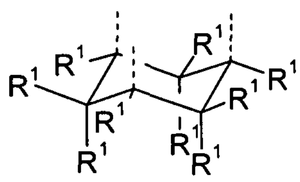
formule (4)

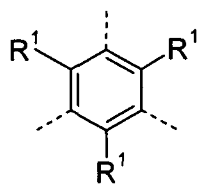
formule (5)

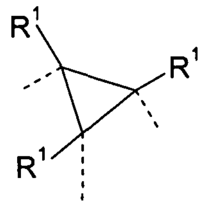
formule (6)

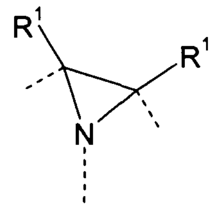
formule (7)

où les liens en pointillés indiquent dans chaque cas la liaison sur Y;

Z est $BR^1$, $B(R^1)_2^-$, $C(R^1)_2$, C(=O), $Si(R^1)_2$, $NR^1$, $PR^1$, $P(R^1)_2^+$, $PO(R^1)$, $PS(R^1)$, $AsR^1$, $AsO(R^1)$, AsS, O, S, Se, ou une unité des formules (8) à (17),

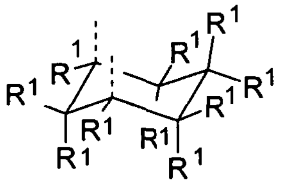
formule (8)

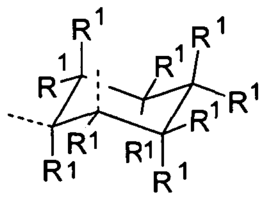
formule (9)

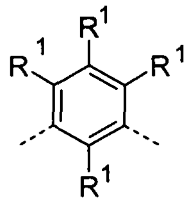
formule (10)

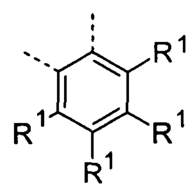
formule (11)

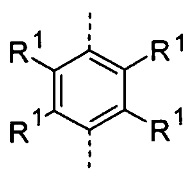
formule (12)

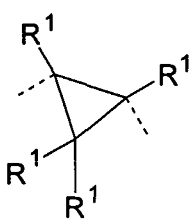
formule (13)

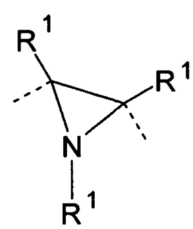
formule (14)

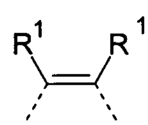
formule (15)

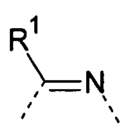
formule (16)

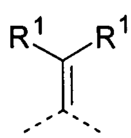
formule (17)

où les liens en pointillés indiquent dans chaque cas la liaison sur Y ;

n est 1, 2 ou 3, de préférence 2 ou 3 ;
m est 1 ou 2, de préférence 2.

**8.** Dispositif électronique selon la revendication 7, **caractérisé en ce que** le nombre d'atomes dans les deux groupes Y et dans le groupe V ou Z qui représentent la connexion directe entre les groupes isonitrile ou entre le groupe isonitrile et le groupe de ligand L est entre 6 et 12 atomes, de préférence entre 7 et 10 atomes, de façon particulièrement préférable entre 7 et 9 atomes.

**9.** Dispositif électronique selon la revendication 7 ou 8, **caractérisé en ce que** les ligands sont choisis parmi des ligands des formules (18) à (28), dont chacun peut être substitué par un ou plusieurs radicaux $R^1$ :

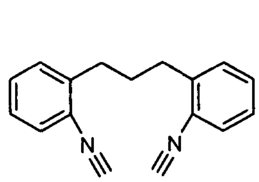

formule (18)

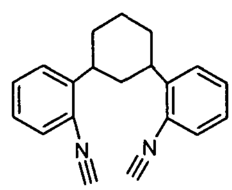

formule (19)

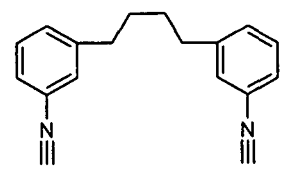

formule (20)

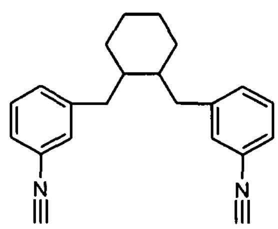

formule (21)

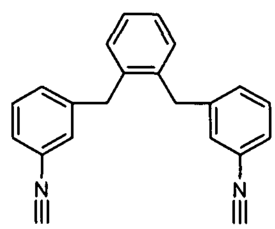

formule (22)

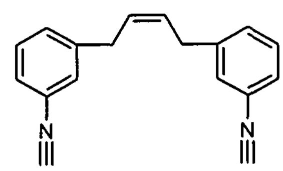

formule (23)

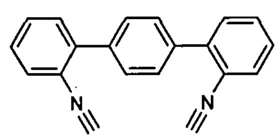

formule (24)

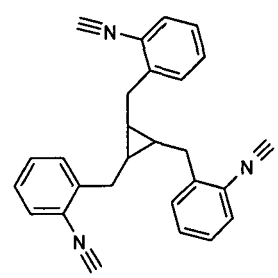

formule (25)

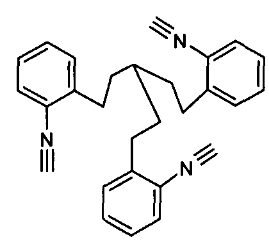

formule (26)

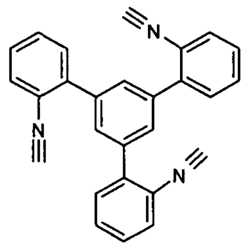 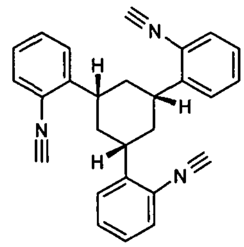

formule (27) formule (28)

**10.** Dispositif électronique selon une ou plusieurs des revendications 1 à 9, **caractérisé en ce que** les ligands L sont choisis parmi le monoxyde de carbone, le monoxyde d'azote, les amines, les phosphines, les phosphites, les arsines, les stibines, les hétérocycles contenant de l'azote, les carbènes, hydrure, deutérure, les halogénures F, Cl, Br et I, les alkylacétylures, les arylacétylures, cyanure, azide, cyanate, isocyanate, thiocyanate, isothiocyanate, les alcoholates aliphatiques ou aromatiques, les thioalcoholates aliphatiques ou aromatiques, les amides, les carboxylates, des groupes aryle, des hétérocycles contenant de l'azote anioniques, $O^{2-}$, $S^{2-}$, les carbures, lesquels conduisent à une coordination sous la forme R-C≡M, et les nitrènes, lesquels conduisent à une coordination sous la forme R-N=M, où R représente de façon générale un substituant, ou $N^{3-}$, les diamines, les imines, les diimines, les hétérocycles contenant deux atomes d'azote, les diphosphines, les 1,3-dicétonates dérivés des 1,3-dicétones, les 3-cétonates dérivés des 3-cétoesters, les carboxylates dérivés des acides aminocarboxyliques, les salicyliminates dérivés des salicylimines, les dialcoholates dérivés des dialcools, les dithiolates dérivés des dithiols, les borates d'hétérocycles contenant de l'azote, $\eta^5$-cyclopentadiényle, $\eta^5$-pentaméthylcyclopentadiényle, $\eta^6$-benzène ou $\eta^7$-cycloheptatriényle, dont chacun peut être substitué par un ou plusieurs radicaux $R^1$, ou **en ce que** le ligand L est un ligand bidenté monoanionique qui, avec le métal, forme un cycle à cinq ou six éléments cyclométallaté avec au moins une liaison métal-carbone, en particulier une combinaison de deux groupes, comme représenté par les formules (29) à (56), où un groupe est lié via un atome d'azote neutre ou un atome de carbone et l'autre groupe est lié via un atome de carbone chargé négativement ou un atome d'azote chargé négativement, où le ligand L est alors formé à partir des groupes des formules (29) à (56) par l'intermédiaire de ces groupes se liant les uns aux autres dans chaque cas à la position indiquée par #, et la position au niveau de laquelle les groupes se coordonnent sur le métal est indiquée par *:

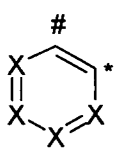 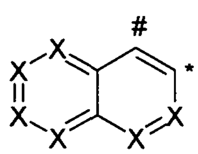 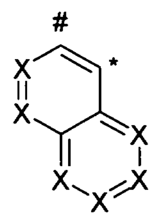 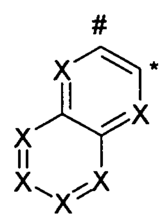

formule (29) formule (30) formule (31) formule (32)

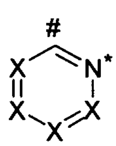 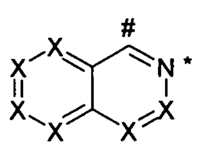 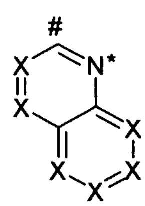 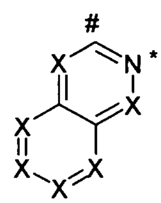

formule (33) formule (34) formule (35) formule (36)

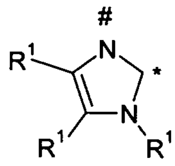

formule (37)

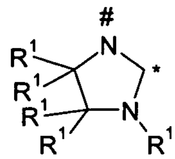

formule (38)

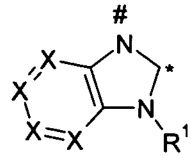

formule (39)

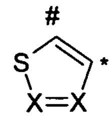

formule (40)

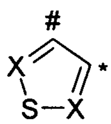

formule (41)

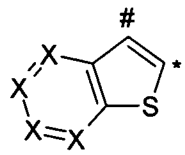

formule (42)

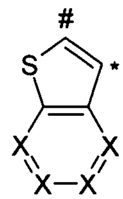

formule (43)

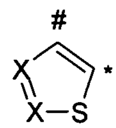

formule (44)

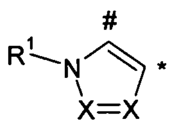

formule (45)

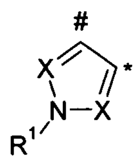

formule (46)

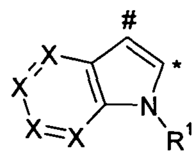

formule (47)

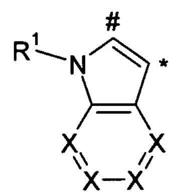

formule (48)

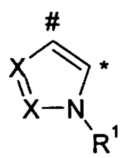

formule (49)

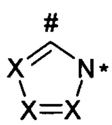

formule (50)

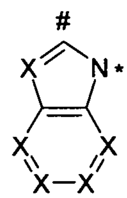

formule (51)

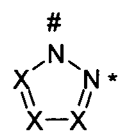

formule (52)

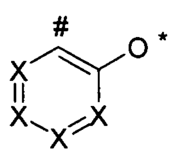

formule (53)

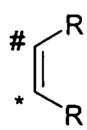

formule (54)

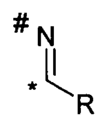

formule (55)

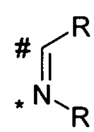

formule (56)

les symboles utilisés ici présentent la même signification que décrit dans la revendication 1, et X représente, de manière identique ou différente pour chaque occurrence, $CR^1$ ou N, étant entendu qu'un maximum de trois symboles X dans chaque groupe représente N ; ou **en ce que** le ligand L est un dérivé de 1,3,5-cis-cyclohexane, en particulier de la formule (57), un dérivé de 1,1,1-tri(méthylène)-méthane, en particulier de la formule (58), ou un méthane 1,1,1-tri-substitué, en particulier des formules (59) et (60),

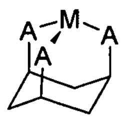

formule (57)

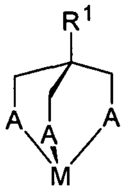

formule (58)

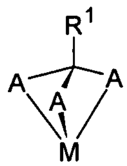

formule (59)

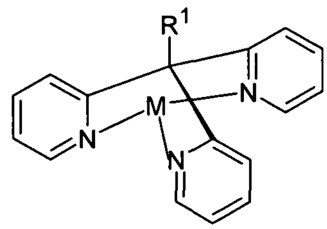

formule (60)

où la coordination sur le métal M est représentée dans chacune des formules, $R^1$ présente la signification mentionnée dans la revendication 1, et A représente, de manière identique ou différente pour chaque occurrence, $O^-$, $S^-$, $COO^-$, $P(R^1)_2$ ou $N(R^1)_2$.

**11.** Dispositif électroluminescent organique selon une ou plusieurs des revendications 1 à 10, comprenant une cathode, une anode et une ou plusieurs couches émettrice et en outre en option, dans chaque cas une ou plusieurs couches d'injection de trous, couches de transport de trous, couches de blocages de trous, couches de transport d'électrons, couches d'injection d'électrons, couches de blocage d'excitons, couches de génération de charges et/ou jonctions p/n organiques ou inorganiques, **caractérisé en ce que** le composé de la formule (1) est utilisé en tant que matériau d'émission dans une couche émettrice.

**12.** Dispositif électroluminescent organique selon une ou plusieurs des revendications 1 à 11, **caractérisé en ce que** le composé de la formule (1) est utilisé dans une couche émettrice en combinaison avec un ou plusieurs matériaux de matrice, en particulier choisis parmi CBP (N,N-biscarbazolylbiphényle), les/des dérivés de carbazole, les azacarbazoles, les cétones, les oxydes de phosphine, les sulfoxydes, les sulfones, les oligophénylènes, les amines aromatiques, les matériaux de matrice bipolaires, les silanes, les dérivés de 9,9-diarylfluorène, les azaboroles et les esters boroniques.

**13.** Procédé pour la fabrication d'un dispositif électronique selon une ou plusieurs des revendications 1 à 12, **caractérisé en ce qu'**une ou plusieurs couches sont appliquées au moyen d'un procédé de sublimation et/ou **en ce qu'**une ou plusieurs couches sont appliquées au moyen du procédé OVPD (dépôt d'organiques en phase vapeur) ou à l'aide d'une sublimation par gaz porteur ou au moyen du procédé OVJP (impression par jet de vapeur organique) et/ou **en ce qu'**une ou plusieurs couches sont produites à partir d'une solution ou au moyen d'un procédé d'impression.

**14.** Composé de la formule (1'),

$$(L)_y\, M[C{\equiv}N\text{-}R]_x \qquad \text{formule (1')}$$

où les symboles et indices utilisés présentent les significations mentionnées dans la revendication 1, et au moins l'un des ligands d'isonitrile est choisi parmi les ligands de la formule (27) ou (28), chacun d'eux pouvant également être substitué par un ou plusieurs radicaux $R^1$:

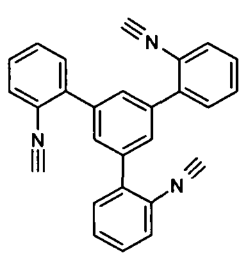

formule (27)

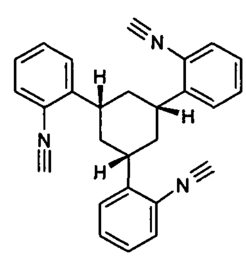

formule (28) .

**15.** Composé de la formule (27) ou (28), chacun pouvant être substitué par un ou plusieurs radicaux $R^1$, où $R^1$ présente la signification mentionnée dans la revendication 1 :

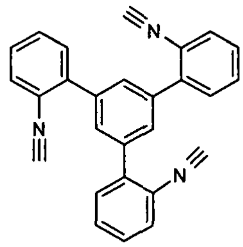

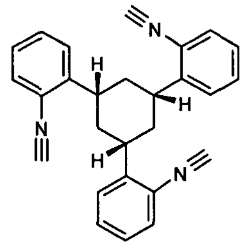

formule (27) formule (28) .

**16.** Solution ou formulation comprenant au moins un composé de la formule (1') et au moins un solvant organique, de préférence choisi parmi la classe des solvants organiques aromatiques.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 04081017 A
- WO 05113563 A
- WO 06008069 A
- JP 2006303315 A
- WO 08003464 A
- WO 2005086251 A
- WO 05011013 A
- WO 05039246 A
- US 20050069729 A
- JP 2004288381 A
- EP 1205527 A
- WO 08086851 A
- EP 1617710 A
- EP 1617711 A
- EP 1731584 A
- JP 2005347160 A
- WO 04093207 A
- DE 102008033943
- WO 05003253 A
- WO 07137725 A
- WO 05111172 A
- DE 102008017591
- WO 06117052 A
- WO 07063754 A
- WO 08056746 A
- DE 102008036982
- EP 652273 A
- DE 102007053771
- WO 2004037887 A2


### In der Beschreibung aufgeführte Nicht-Patentliteratur


- **M. A. BALDO et al.** *Appl. Phys. Lett.,* 1999, vol. 75, 4-6
- **Y. YAMAMOTO et al.** *J. Organomet. Chem.,* 1985, vol. 282, 191-200
- **M. O. ALBERS et al.** *J. Chem. Edu.,* 1986, vol. 63 (5), 444-447
- **B. F. E. HAHN et al.** *J. Organomet. Chem.,* 1994, vol. 467, 103-111
- **F. E. HAHN et al.** *J. Organomet. Chem.,* 1991, vol. 410, C9-C12
- **F. E. HAHN et al.** *Angew. Chem.,* 1992, vol. 104, 1218-1221
- **F. E. HAHN et al.** *Angew. Chem.,* 1991, vol. 103, 213-215
- **D. T. PLUMMER et al.** *Inorganic Chemistry,* 1983, vol. 22, 3492-3497
- **ELSCHENBROICH ; SALZER.** *Organometallchemie,* 1993
- **F. E. HAHN et al.** *J. Organomet. Chem.,* 1994, vol. 467, 103-111
- **F. E. HAHN et al.** *Angew. Chem.,* vol. 104, 1218-1221
- **F. E. HAHN et al.** *Organometallics,* 1994, vol. 13, 3002-3008
- **F. E. HAHN et al.** *Organometallics,* 1992, vol. 11, 84-90
- **ALBERS et al.** *J. Chem. Edu.,* 1986, vol. 63 (5), 444
- **COVILLE et al.** *Inorg. Chim. Acta,* 1982, vol. 65, L7-L8
- **YAMAMOTO et al.** *J. Organomet. Chem.,* 1985, vol. 282, 191
- **HAHN et al.** *Organometallics,* 1994, vol. 13, 3002
- **F. HAHN et al.** *Organometallics,* 1992, vol. 11, 84
- **M. S. ARNOLD et al.** *Appl. Phys. Lett.,* 2008, vol. 92, 053301
- **F.E. HAHN et al.** *J. Organomet. Chem.,* 1994, vol. 467, 130
- **K. MANN et al.** *J. Am. Chem. Soc,* 1977, vol. 99 (1), 306